(19) Europäisches Patentamt
European Patent Office
Office européen des brevets

(11) **EP 3 479 410 B1**

(12) **EUROPEAN PATENT SPECIFICATION**

(45) Date of publication and mention
of the grant of the patent:
**05.08.2020 Bulletin 2020/32**

(21) Application number: **17733450.5**

(22) Date of filing: **27.06.2017**

(51) Int Cl.:
*H01L 29/78* (2006.01)      *H01L 29/10* (2006.01)
*H01L 21/336* (2006.01)

(86) International application number:
**PCT/EP2017/065852**

(87) International publication number:
**WO 2018/002048 (04.01.2018 Gazette 2018/01)**

(54) **SHORT CHANNEL TRENCH POWER MOSFET**

GRABEN-LEISTUNGS-MOSFET MIT KURZEM KANAL

MOSFET DE PUISSANCE À TRANCHÉE À CANAL COURT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **29.06.2016 EP 16176786**

(43) Date of publication of application:
**08.05.2019 Bulletin 2019/19**

(73) Proprietor: **ABB Power Grids Switzerland AG
5400 Baden (CH)**

(72) Inventors:
• **KNOLL, Lars
5607 Hägglingen (CH)**
• **MINAMISAWA, Renato
5210 Windisch (CH)**

(74) Representative: **Kuhnen & Wacker
Patent- und Rechtsanwaltsbüro PartG mbB
Postfach 1964
85319 Freising (DE)**

(56) References cited:
**US-A1- 2006 081 920      US-A1- 2008 206 944
US-A1- 2008 283 909      US-A1- 2011 018 004
US-A1- 2012 080 748      US-A1- 2014 306 284
US-A1- 2016 172 482**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Field of the invention

The present invention relates to a short channel trench power MOSFET, and to a method for manufacturing the same.

Background of the invention

From US 2011/018004 A1 a semiconductor device with large blocking voltage is provided utilizing silicon carbide trench MOSFET possessing both narrow regions where the p body concentration is low, and wide regions where the p body concentration is high. A channel region with a lower doping level and a thickness of 50 nm is described to be provided on the gate insulation layer.

From US 2008/0283909 A1 there is known a semiconductor device which includes a second-conductivity-type base region provided on a first-conductivity-type semiconductor layer, a first-conductivity-type source region provided on the second-conductivity-type base region, a gate insulating film covering an inner wall of a trench which passes through the second-conductivity-type base region and reaching the first-conductivity-type semiconductor layer, a gate electrode buried in the trench via the gate insulating film, and a second-conductivity-type region being adjacent to the second-conductivity-type base region below the first-conductivity-type source region, spaced from the gate insulating film, and having a higher impurity concentration than the second-conductivity-type base region. Therein, $c \geq d$ is satisfied, where d is a depth from an upper surface of the first-conductivity-type source region to a lower end of the gate electrode, and c is a depth from an upper surface of the first-conductivity-type source region to a lower surface of the second-conductivity-type base region.

From US 2012/0080748 A1 there is known a trench MOSFET with short channel length and super pinch-off regions, wherein the super pinch-off regions are implemented by forming at least two type pinch-off regions for punch-through prevention: a first type pinch-off region with a wide mesa width generated between lower portion of two adjacent trenched gates and below an anti-punch through region surrounding bottom of a trenched source-body contact filled with metal plug; a second type pinch-off region with a narrow mesa width generated below a body region and between upper portion of one trenched gate and the anti-punch-through region along sidewall of the trenched source-body contact.

According to US 2008/0206944 A1 a known method uses simplified processes to complete the forming of the trench DMOS transistors and Schottky contacts. In the processes, only four masks, i.e. a trench pattern mask, a contact-hole pattern mask, a P+ contact pattern mask and a conductive-wire pattern mask, are applied to create desired trench DMOS transistors. In addition to the trench DMOS transistors, a Schottky contact is simultaneously formed at a junction between a conductive layer and a doped body region in the trench DMOS transistors without additional photolithography process.

From US 2006/0081920 A1 there is known a method for manufacturing a trench MOSFET wherein a trench is formed into a stack of a semiconductor substrate of the first-type, a semiconductor region of the first-type formed on the substrate, a base layer of the second-type on the semiconductor region and a source region of the first-type in the vicinity of a top surface of the base layer. A semiconductor device manufactured by the method disclosed in this prior art includes: the semiconductor substrate of the first-type; the semiconductor region of the first-type formed on the substrate; a gate electrode a part of which is present within the trench selectively formed in part of the semiconductor region, and an extended top-end to have a wide width via a stepped-portion; a gate insulating-film formed between the trench and the gate electrode along a wall surface of the trench; the base layer of the second-type on the region via the film to enclose a sidewall except a bottom of the trench; the source region of the first-type adjacent to the film outside the trench in the vicinity of a top surface of the base layer; and an insulating-film formed partially between a bottom-surface of the top-end and a top-surface of the source region and formed to have a thickness larger than that of the gate insulating-film within the trench.

Among different structures of power metal oxide semiconductor field effect transistor (MOSFET) devices, trench power MOSFETs have the advantage that the on-state resistance is relatively low. In a trench power MOSFET a current is conducted vertically from a source electrode on a first main side (i.e. a first main side surface) of the wafer to a drain electrode on a second main side (i.e. a second main side surface) of the wafer opposite to the first main side. To achieve a high drive capability a plurality of trenches penetrate through a p-doped base region below the first main side of the wafer. Inside of each trench there is formed a gate dielectric and a gate electrode to control the current conduction from an n-doped source region through a channel region in the p-doped base region adjacent to the trenches to an n⁻-doped drift region by the field effect. The area between two trenches corresponds to a MOSFET cell. All the MOSFET cells are connected between the source electrode and the drain electrode in parallel in order to reduce the on-state resistance. The n⁻-doped drift region between the channel regions of the plurality of MOSFET cells and an n⁺-doped drain layer in contact with the drain electrode allows a large voltage in off-state condition. In the on-state condition, the charge carriers drift through the n⁻-drift region towards the n⁺-doped drain layer due to the potential difference across it.

The power semiconductor industry is strongly moving toward scaling, which requires the improvement of the device electrostatics. Reducing the channel length in the known trench power MOSFET can strongly reduce on-state losses, however, at the cost of a shift of the threshold voltage $V_{th}$ and at the cost of early breakdown in reverse blocking.

For a high reverse blocking capability it is crucial to design the p-doped base region in a way to avoid leakage current under depletion to the n⁺-doped source region. In a common trench power MOSFET the p-doped base region is implemented as a semiconductor layer having a typical thickness of about 1 μm and a moderate doping concentration of about $10^{17}$ cm⁻³. Reducing the layer thickness of the p-doped base region and thus reducing the channel length would inevitably require higher doping, which in turn, would degrade the channel mobility due to coulombic scattering and significant shift of $V_{th}$ towards positive polarity.

In prior art document WO 2015/104084 A1 there is disclosed a silicon carbide (SiC) trench MOSFET transistor device with a plurality of trench MOSFET cells, wherein additional p⁺-doped regions having a higher doping concentration than a remaining p-doped base region are arranged between neighboring trench MOSFET cells to reduce an electric field acting on the gate dielectric at lower edges of the trenches, in which the gate dielectric is formed.

From prior art document US 8 476 697 B1 there is known a SiC power double-diffused metal oxide semiconductor field effect transistor (DMOSFET) having a channel length of about 0.5 μm. A p-doped base region has a peak concentration of about $1 \cdot 10^{18}$ cm⁻³ to $3 \cdot 10^{18}$ cm⁻³ in order to avoid punch-through. The doping profile of the p-doped base region is a retrograde doping profile with p-type doping concentration of about $2.5 \cdot 10^{17}$ cm⁻³ or greater in a channel region and about $1 \cdot 10^{18}$ cm⁻³ to $3 \cdot 10^{18}$ cm⁻³ near the p-n junction between the p-doped base region and the n⁻-doped drift region. In order to avoid high oxide fields at threshold the channel region is counter-doped with an n-type dopant with a doping concentration of about $3 \cdot 10^{17}$ cm⁻³ to $8 \cdot 10^{17}$ cm⁻³, whereby, after compensation, the surface is n-type with a net doping concentration of about $1 \cdot 10^{17}$ cm⁻³ to $3 \cdot 10^{17}$ cm⁻³ up to a counter doping depth of 60 nm. There is also described a silicon carbide UMOSFET device, wherein a surface n-type layer is obtained by angled ion implantation into the trench sidewalls following trench etch. However, the power MOSFETs disclosed in US 8 476 697 B1 suffer from short-channel effects and a high subthreshold slope.

From US 5 547 882 A there is known a method for forming a retrograde semiconductor substrate channel impurities profile of a semiconductor device by using phosphorus ions implantation, including the steps of forming a sacrificial oxide layer on a semiconductor substrate, ion-implantation of boron ions to adjust a threshold voltage of the device, removing the sacrificial oxide layer, forming a gate oxide layer on the semiconductor substrate, depositing a gate polysilicon layer on the gate oxide layer, forming a gate by etching the gate polysilicon layer, ion-implanting firstly by implanting phosphorus ions to form lightly doped drain regions, and ion-implanting secondly by implanting phosphorus ions into the semiconductor substrate channel to form the retrograde channel impurities profile as well as to achieve a proper threshold voltage.

Summary of the invention

It is an object of the invention to provide a power semiconductor device having a low on-state resistance while avoiding any short channel effects and having a low subthreshold slope.

The object of the invention is attained by a power semiconductor device according to claim 1. The power semiconductor device according to the invention is a trench power field effect transistor, which comprises a drift layer having a first conductivity type, a base layer having a second conductivity type, which is different from the first conductivity type, a source layer having the first conductivity type, a channel region having the second conductivity type and a trench gate structure for controlling an electrical conductivity of the channel region. The base layer is provided on the drift layer to form a first p-n junction. The source layer is provided on the base layer to form a second p-n junction. The channel region extends from the source layer to the drift layer, so that the channel region forms a third p-n junction with the source layer and a fourth p-n junction with the drift layer. The trench gate structure includes an electrically conductive gate electrode and a gate insulation layer electrically insulating the gate electrode from the channel region. At all locations within the channel region a first local doping concentration is less than $1 \cdot 10^{17}$ cm⁻³. In the base layer a second local doping concentration is at least $1 \cdot 10^{17}$ cm⁻³ at all locations within the base layer. The channel region and the base layer are in direct contact with each other. In the invention a channel length $L_{CH}$, which is defined as a length of a shortest path from the third p-n junction to the fourth p-n junction along an interface between the channel region and the gate insulation layer, fulfils the following inequation:

$$L_{CH} > 4\sqrt{\left(\frac{\varepsilon_{CH} t_{CH} t_{GI}}{\varepsilon_{GI}}\right)}, \qquad\qquad (1)$$

wherein $\varepsilon_{CH}$ is a permittivity of the channel region, $\varepsilon_{GI}$ is a permittivity of the gate insulation layer, $t_{CH}$ is a thickness of the channel region in a direction perpendicular to an interface between the gate insulation layer and the channel region, and $t_{GI}$ is a thickness of the gate insulation layer in a direction perpendicular to the interface between the gate insulation layer and the channel region.

By satisfying inequation (1) short channel effects in the trench power field effect transistor device can be avoided and a subthreshold slope is relatively low. An optimum threshold voltage even for a short channel length where prior art trench power field effect transistors show significant short channel effects can be achieved with the power semiconductor device of the invention.

The thickness $t_{CH}$ of the channel region is in a range from 1 nm to 10 nm. In this exemplary embodiment a good gate control can be achieved while avoiding any short channel effects. The lower limit of 1 nm ensures efficient reduction of the threshold voltage $V_{th}$ and increase of the channel carrier mobility, while the upper limit ensures that short channel effects can be reduced especially efficient. In another exemplary embodiment the thickness $t_{CH}$ of the channel region is in a range from 2 nm to 5 nm.

A mean value of the first local doping concentration in the channel region is less than $4 \cdot 10^{16}$ cm$^{-3}$. A low mean value of the first local doping concentration in the channel region is an effective means to avoid any short channel effects, to reduce the subthreshold slope and to achieve a good off-state capability. Exemplarily the mean value of the first local doping concentration in the channel region is less than $2 \cdot 10^{16}$ cm$^{-3}$. Throughout the specification the term doping concentration shall refer to a net doping concentration, i.e. an absolute value of the difference between the concentration of donors and the concentration of acceptors.

In an exemplary embodiment the channel length $L_{CH}$ is less than 0.6 $\mu$m, or less than 0.5 $\mu$m, or less than 0.4 $\mu$m, or less than 0.3 $\mu$m. A short channel length $L_{CH}$ as in these exemplary embodiments results in a low on-state resistance. That means that the on-state losses are relatively low in this exemplary embodiment compared to an embodiment with a larger channel length $L_{CH}$.

In an exemplary embodiment a mean value of the second local doping concentration in the base layer is at least $5 \cdot 10^{17}$ cm$^{-3}$ or at least $1 \cdot 10^{18}$ cm$^{-3}$ or at least $5 \cdot 10^{18}$ cm$^{-3}$. Such high doping concentration in the base layer can efficiently avoid reach-through breakdown in the blocking mode.

In an exemplary embodiment the drift layer, the base layer, the channel region and the source layer are made of silicon carbide. Silicon carbide has a large bandgap, a high thermal conductivity and a high melting point. These properties make silicon carbide ideally suited for high-temperature applications. In addition, silicon carbide has a high critical field and a high electron saturation velocity. Therefore, silicon carbide is particularly suited for high power devices. It allows a higher operating electric field, a higher operating temperature, a higher switching frequency and lower losses than silicon.

In an exemplary embodiment a depth of the base layer is larger than the depth of the channel region. That means that a minimum distance of the first p-n junction to a surface of the drift layer opposite to the second p-n junction (i.e. a surface of the drift layer on a drain-side of the device) is less than a minimum distance of the fourth p-n junction to the surface of the drift layer opposite to the second p-n junction. In such exemplary embodiment the deep base layer can protect the gate insulation layer from high electric fields during operation of the device.

In an exemplary embodiment a base electrode region penetrates into the base layer to form a trench contact to the base layer. With such trench contact to the base layer the base layer can be formed by applying an impurity of the second conductivity type through a trench in a relatively low doped semiconductor layer of the second conductivity type. The portion of the low doped semiconductor layer of the second conductivity type, which is not doped by the impurity of the second conductivity type forms the channel region in the final device. Accordingly, the trench contact to the base layer allows manufacturing of the power semiconductor device of the invention with a lateral retrograde doping profile in an efficient and reliable manner.

In an exemplary embodiment a gradient of the local doping concentration at an interface between the channel region and the base layer is at least $10^{16}$ cm$^{-3}$/nm. In such embodiment with a sharp increase of the doping level at the interface between the channel region and the base layer a good gate control can be achieved and short channel effects can be avoided most efficiently.

A power semiconductor device according to the invention can be manufactured by a method according to any one of claim 9 to 14.

Brief description of the drawings

Detailed embodiments of the invention will be explained below with reference to the accompanying figures, in which:

Fig. 1          shows a partial cross sectional view of a power semiconductor device according to a first embodiment of the invention;

Fig. 2          shows an enlarged portion of the cross sectional view in Fig. 1;

Fig. 3                    shows a partial cross sectional view of a power semiconductor device according to a second embodiment of the invention;

Fig. 4                    shows an enlarged portion of the cross sectional view in Fig. 3;

Fig. 5                    shows a partial cross sectional view of a power semiconductor device according to a third embodiment of the invention;

Fig. 6                    shows an enlarged portion of the cross sectional view in Fig. 5;

Fig. 7                    shows a partial cross sectional view of a power semiconductor device according to a fourth embodiment of the invention;

Fig. 8                    shows an enlarged portion of the cross sectional view in Fig. 7;

Fig. 9                    shows a drain current $I_D$ - gate voltage $V_G$ characteristics for three different trench power MOSFET devices at a drain voltage of 0.5 V;

Figs. 10A to 10F    illustrate a first embodiment of a method for manufacturing a power semiconductor device;

Fig. 11A to 11F     illustrate a second embodiment of a method for manufacturing a power semiconductor device ;

Figs. 12A to 12F    illustrate a third embodiment of a method for manufacturing a power semiconductor device according to the invention;

Figs. 13A to 13F    illustrate a fourth embodiment of a method for manufacturing a power semiconductor device;

Fig. 14              illustrates a modification of the second embodiment of a method for manufacturing a power semiconductor device; and

Fig. 15              illustrates a modification of the third embodiment of a method for manufacturing a power semiconductor device.

The reference signs used in the figures and their meanings are summarized in the list of reference signs. Generally, similar elements have the same reference signs throughout the specification. The described embodiments are meant as examples and shall not limit the scope of the invention.

Detailed Description of preferred embodiments

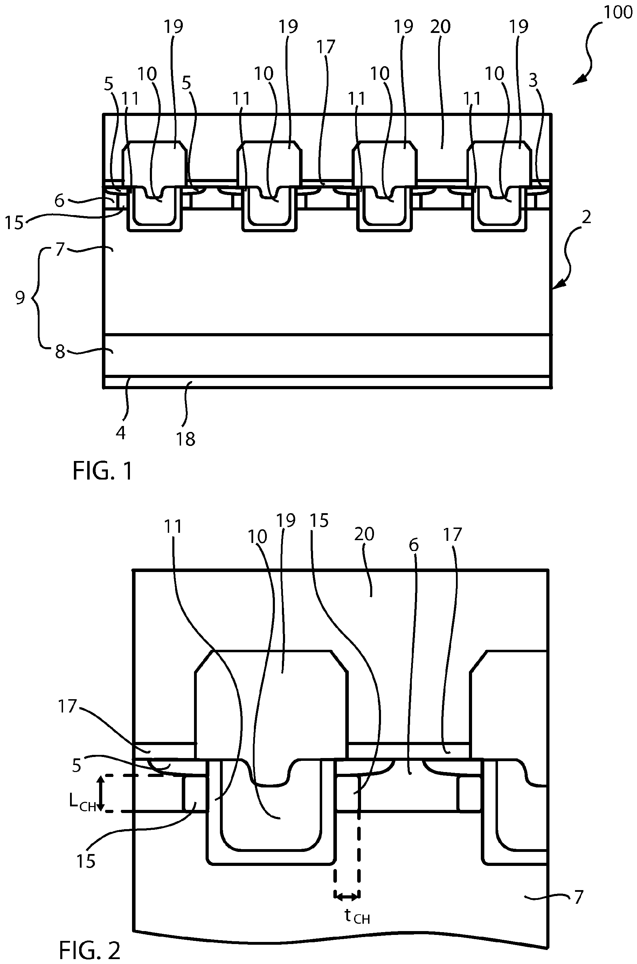

In Fig. 1 there is shown a cross sectional view of a power semiconductor device according to a first embodiment of the invention. Fig. 2 shows an enlarged portion of Fig. 1. The power semiconductor device according to the first embodiment of the invention is a trench power metal oxide semiconductor field effect transistor (trench power MOSFET) 100. It comprises a semiconductor wafer 2 having a first main side 3 and a second main side 4. Exemplarily the semiconductor wafer is a silicon carbide (SiC) wafer. Throughout the specification the term silicon carbide may refer to any polytype of silicon carbide, in particular it may refer to 4H-SiC or 6H-SiC. In an order from the first main side 3 to the second main side 4, the SiC wafer 2 comprises an $n^+$-doped source layer 5, a p-doped base layer 6, an $n^-$-doped drift layer 7 and an $n^+$-doped drain layer 8. The drift layer 7 and the drain layer 8 form an n-doped substrate layer 9. The source layer 5 is separated from the drift layer 7 by the base layer 6, and the base layer 6 is separated from the drain layer 8 by the drift layer 7. Specifically, the base layer 6 is provided on the drift layer 7 to form a first p-n junction, and the source layer 5 is provided on the base layer 6 to form a second p-n junction.

A plurality of trench gate structures penetrate through the base layer 6. Each gate electrode structure includes an electrically conductive gate electrode 10 and a gate insulation layer 11. The gate electrode structure is configured to control an electrical conductivity of a channel region 15 adjacent thereto by an electrical field when applying an electrical potential to the gate electrode 10. Each channel region extends from the source layer 5 to the drift layer 7, so that the channel region 15 forms a third p-n junction with the source layer and a fourth p-n junction with the drift layer 7. The gate insulation layer 11 electrically insulates the gate electrode 10 from the drift layer 7, from the channel region 15 and from the source layer 5. In particular the gate insulation layer 11 is sandwiched between the channel region 15 and the gate electrode 10 to be in direct contact with the channel region 15 and with the gate electrode 10, respectively. Throughout the specification of the present patent application, no other elements are arranged between two layers or regions when two layers or regions are described to be in direct contact with each other.

In a plane parallel to and below the first main side 3, gate electrodes 10, may have a cross-section of any shape, exemplarily a longitudinal line shape, a honeycomb shape, a polygonal shape, a round shape or an oval shape.

At all locations within the channel region 15 a first local doping concentration, i.e. a maximum doping concentration in the channel region 15, is less than $1 \cdot 10^{17}$ cm$^{-3}$ (all local doping concentrations at a location within the channel region are referred to as a first local doping concentration). In the base layer 6 a second local doping concentration, i.e. a minimum doping concentration in the base layer 6, is at least $1 \cdot 10^{17}$ cm$^{-3}$ at all locations within the base layer 6 (all local doping concentrations at a location within the base layer 6 are referred to as a second local doping concentration). The channel region 15 and the base layer 6 are in direct contact with each other. The maximum doping concentration in the channel region 15 is lower than the minimum doping concentration in the base layer 6.

A thickness $t_{CH}$ of the channel region 15 in a direction perpendicular to the interface between the gate insulation layer 11 and the channel region 15, a channel length $L_{CH}$, which is defined as the length of the shortest path from the source layer 5 to the drift layer 7 (i.e. from the third p-n junction the fourth p-n junction) on the interface between the gate insulation layer 11 and the channel region 15, and a thickness $t_{GI}$ of the gate insulation layer 11 in a direction perpendicular to the interface between the gate insulation layer 11 and the channel region 15 fulfil the following inequation:

$$ L_{CH} > 4\sqrt{\left(\frac{(\varepsilon_{CR}t_{CH}t_{GI})}{\varepsilon_{GI}}\right)} \qquad (1), $$

wherein $\varepsilon_{CR}$ is a permittivity of the channel region and $\varepsilon_{GI}$ is a permittivity of the gate insulation layer 11.

In the first embodiment the thickness $t_{CH}$ of the channel region 15 in a direction perpendicular to the interface between the gate insulation layer 11 and the channel region 15 is constant along the whole interface between the gate insulation layer 11 and the channel region 15. The thickness $t_{CH}$ of the channel region 15 may be in a range from 1 nm to 10 nm, or in a range from 2 nm to 5 nm. The channel length $L_{ch}$ may be less than 0.6 $\mu$m, or less than 0.5 $\mu$m, or less than 0.4 $\mu$m, or less than 0.3 $\mu$m.

In the first embodiment a channel length may be less than 0.6 $\mu$m, or less than 0.5 $\mu$m, or less than 0.4 $\mu$m, or less than 0.3 $\mu$m.

In the first embodiment, a mean value of the second local doping concentration in the base layer (6) may be at least $5 \cdot 10^{17}$ cm$^{-3}$ or at least $1 \cdot 10^{18}$ cm$^{-3}$ or at least $5 \cdot 10^{18}$ cm$^{-3}$. A mean value of the first local doping concentration in the channel region (15) may be less than $4 \cdot 10^{16}$ cm$^{-3}$ or less than $2 \cdot 10^{16}$ cm$^{-3}$. In the first embodiment, a mean value of the second local doping concentration in the base layer (6) may be at least $5 \cdot 10^{17}$ cm$^{-3}$ or at least $1 \cdot 10^{18}$ cm$^{-3}$ or at least $5 \cdot 10^{18}$ cm$^{-3}$. Therein, a mean value of a local doping concentration in a certain region refers to a mean value $\overline{|N_A - N_D|}$ of the local net doping concentration $|N_A - N_D|$, which is calculated according to the following equation:

$$ \overline{|N_A - N_D|} = \frac{1}{V}\int_V |N_A - N_D| \, dV , \qquad (2) $$

wherein $N_A$ is the local concentration of acceptors, $N_D$ is the local concentration of donors, $|N_A - N_D|$ is the local net doping concentration and V is the volume of the certain region for which the mean value is to be calculated.

In a second embodiment shown in Figures Z 3 and 4 a depth of the base layer 6 is larger than the depth of the channel region 15, wherein the depth of a layer or region is defined as a distance between a first main side 3 of the SiC wafer and a location in the layer or region, which is farthest away from the first main side 3 of the SiC wafer.

In the first embodiment a gradient of the local doping concentration at an interface between the channel region 15 and the base layer 6 may be at least $10^{16}$ cm$^{-3}$/nm.

A thickness of the drift layer 7 depends on the nominal voltage, i.e. on the maximum blocking voltage in reverse direction, for which the device is designed. For example, a nominal blocking voltage of 1 kV requires a thickness of the drift layer 7 of about 6 $\mu$m and a nominal blocking voltage of 5 kV requires a thickness of the drift layer 7 of about 36 $\mu$m. The ideal doping concentration of the drift layer 7 depends also on the nominal voltage and is exemplarily in a range between $1 \cdot 10^{15}$ cm$^{-3}$ and $5 \cdot 10^{16}$ cm$^{-3}$. A thickness of the source layer 5 is exemplarily in a range between 0.5 $\mu$m and 5 $\mu$m, while a doping concentration of the source layer 5 is exemplarily $1 \cdot 10^{18}$ cm$^{-3}$ or more. The thicknesses are measured in a direction perpendicular to the first main side 3.

A source electrode 17 is arranged on the first main side 3 of the SiC wafer 2. It forms an ohmic contact to the source layer 5. To avoid triggering of a parasitic bipolar transistor formed by the base layer 6, the source layer 5 and the drift layer 7, the base layer 6 is also electrically connected to the source electrode 17. On the second main side 4 of the SiC wafer 2 a drain electrode 18 is arranged, which forms an ohmic contact to the drain layer 8.

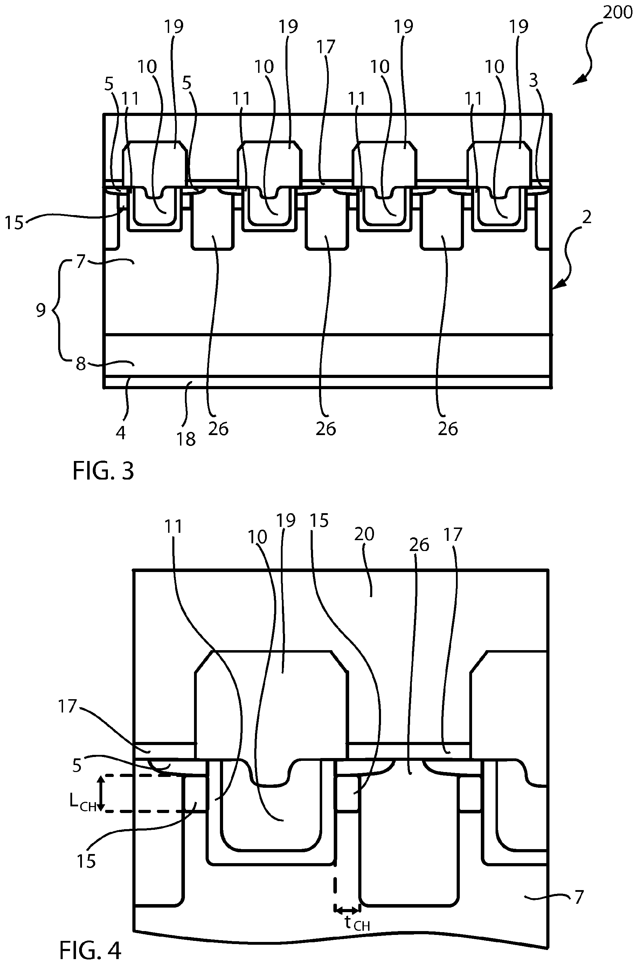

Next, a power semiconductor device according to a second embodiment is described with reference to Figures 3 and 4. Therein, Fig. 3 shows a partial cross sectional view of the power semiconductor device according to the second embodiment and Fig. 4 shows an enlarged portion of the cross sectional view in Fig. 3. Due to the fact that the power semiconductor device according to the second embodiment is very similar to the power semiconductor device according to the first embodiment described above with reference to Figures 1 and 2, only the differences between the first and the second embodiment will be described in the following. With regard to all other features it is referred to the description of the first embodiment above.

The power semiconductor device according to the second embodiment is a trench power MOSFET 200. The second embodiment differs from the first embodiment in that it comprises a base layer 26 having a larger depth than a depth of the channel region 15, whereas the base layer 6 had the same depth as the channel region 15 in the first embodiment. Therein, a depth of the channel region 15 is defined as a vertical distance (i.e. a distance in a vertical direction, which is parallel to the shortest line extending from the source electrode 17 to the drain electrode 18) between the source electrode 17 and a lower end of the channel region 15 farthest away from the source electrode 17. Likewise the depth of the base layer 26 is defined as a vertical distance (i.e. a distance in a vertical direction, which is parallel to the shortest line extending from the source electrode 17 to the drain electrode 18) between the source electrode 17 and a lower end of the base layer 26 farthest away from the source electrode 17. Therein, a vertical distance from the source electrode 17 is the same as the vertical distance from the first main side 3 of the semiconductor wafer 2. In other words a minimum distance of the first p-n junction to a surface of the drift layer opposite to the second p-n junction (i.e. a surface of the drift layer on a drain-side of the device) is less than a minimum distance of the fourth p-n junction to the surface of the drift layer opposite to the second p-n junction. In such exemplary embodiment the base layer 26, which is deeper than the channel region 15, can protect the gate insulation layer 11 from high electric fields during operation of the trench power MOSFET 200.

Besides the above described difference between the depth of the base regions 6 and 26 in the first and second embodiment, respectively, the power semiconductor device according to the second embodiment has the same features as described above for the first embodiment. It may also have all optional features described above for the first embodiment.

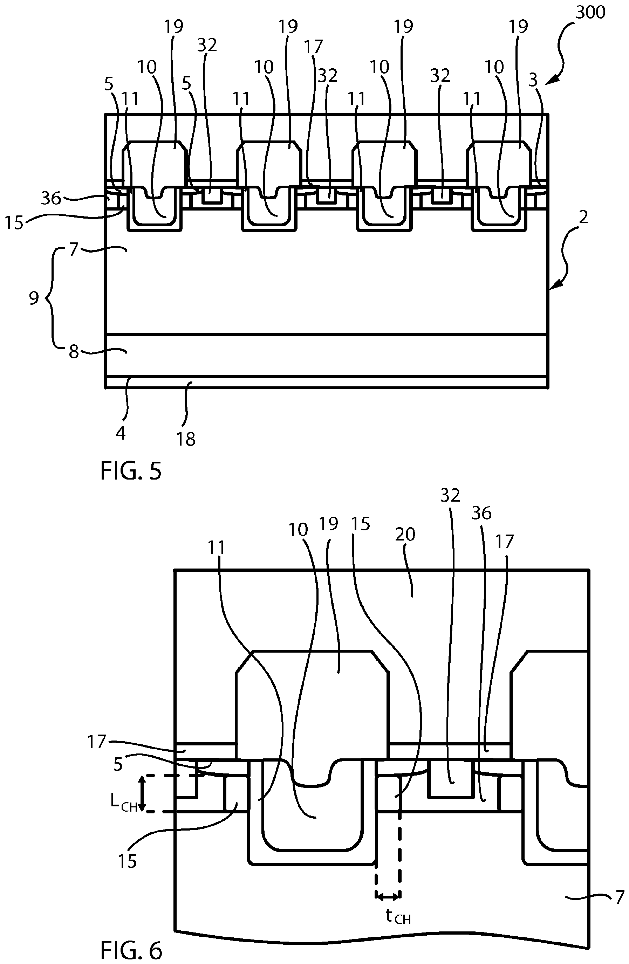

Next, a power semiconductor device according to a third embodiment is described with reference to Figures 5 and 6. Therein, Fig. 5 shows a partial cross sectional view of the power semiconductor device according to the third embodiment and Fig. 6 shows an enlarged portion of the cross sectional view in Fig. 5. Due to the fact that the power semiconductor device according to the third embodiment is very similar to the power semiconductor device according to the first embodiment described above with reference to Figures 1 and 2, only the differences between the first and the third embodiment will be described in the following. With regard to all remaining features it is referred to the description of the first embodiment above.

The trench power MOSFET 300 differs from the trench power MOSFET 100 according to the first embodiment in that a base electrode region 32 penetrates from the first main side 3 of the semiconductor wafer 2 into the base layer 36. The base electrode region 32 is made of a conductive material such as highly p-doped polysilicon and is in electrical contact with the source electrode 17 formed on the first main side 3 of the semiconductor wafer 2. As will be described below, the base electrode region 32 forming a trench contact to the base layer 36 allows manufacturing of the power semiconductor device of the invention with a lateral retrograde doping profile in a particularly efficient and advantageous manner.

Besides the above described difference between the first and the third embodiment, the power semiconductor device according to the third embodiment has the same features as described above for the first embodiment. It may also have all optional features described above for the first embodiment.

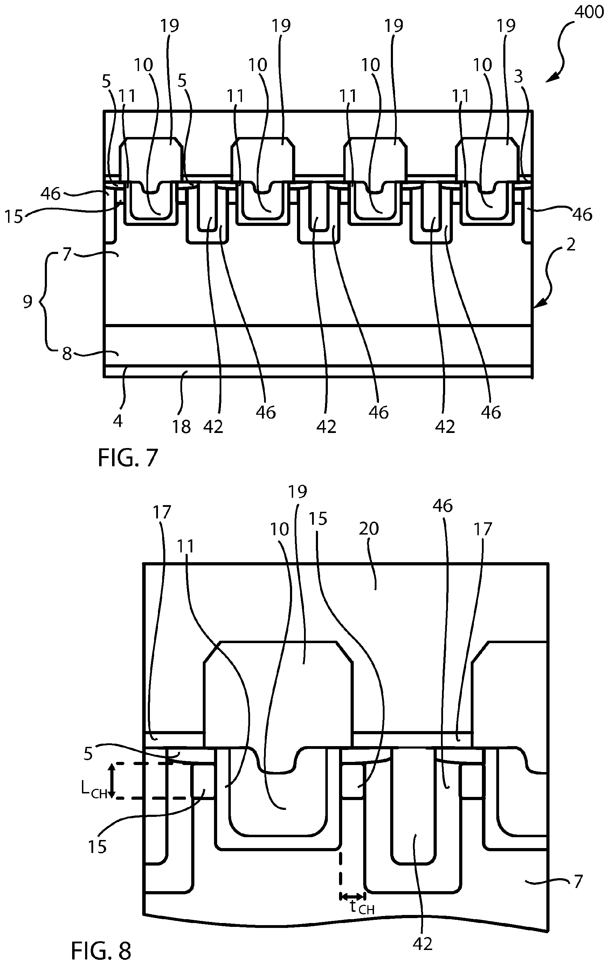

Next, a power semiconductor device according to a fourth embodiment is described with reference to Figures 7 and 8. Therein, Fig. 7 shows a partial cross sectional view of the power semiconductor device according to the fourth embodiment and Fig. 8 shows an enlarged portion of the cross sectional view in Fig. 7. Due to the fact that the power semiconductor device according to the fourth embodiment is very similar to the power semiconductor device according to the second embodiment described above with reference to Figures 3 and 4, only the differences between the second and the fourth embodiment will be described in the following. With regard to all remaining features it is referred to the description of the first and second embodiment above.

The trench power MOSFET 400 of the fourth embodiment differs from the trench power MOSFET 200 according to the second embodiment in that a base electrode region 42 penetrates from the first main side 3 of the semiconductor wafer 2 into the base layer 46. The base electrode region 42 is made of a conductive material such as highly p-doped polysilicon and is in electrical contact with the source electrode 17 formed on the first main side 3 of the semiconductor wafer 2. As will be described below, the base electrode region 42 forming a trench contact to the base layer 46 allows manufacturing of the power semiconductor device of the invention with a lateral retrograde doping profile in a particularly efficient and advantageous manner as in the second embodiment. Moreover, the trench power MOSFET 400 according to the fourth embodiment has similar features and advantages as the trench power MOSFET 200 according to the second embodiment. As in the second embodiment, the depth of base layer 46 is larger than a depth of channel region 15. Accordingly, the base layer 46 can efficiently protect the gate insulation layer 11 from high electric fields during operation of the device as in the second embodiment.

Besides the above described differences between the second and the fourth embodiment, the power semiconductor device according to the fourth embodiment has the same features as described above for the second embodiment. In particular, it may also have all optional (exemplary) features described above for the first embodiment.

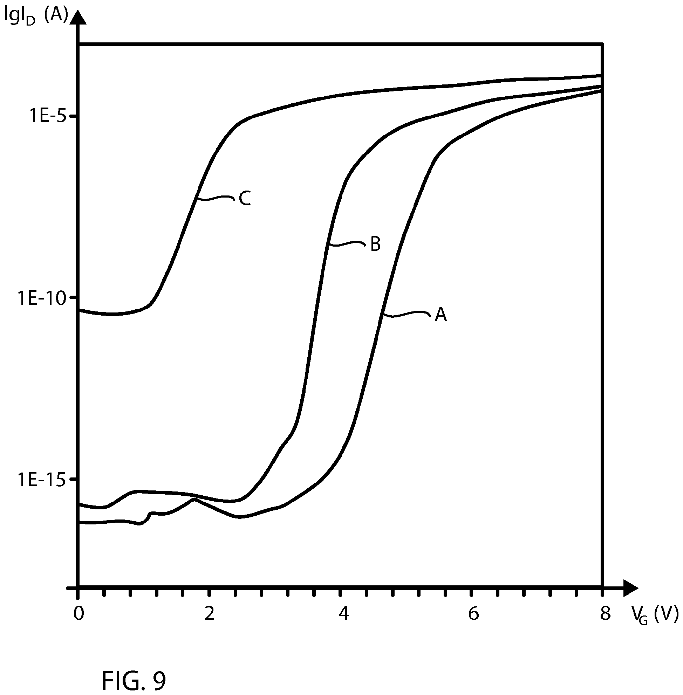

In Fig. 9 there are shown drain current $I_D$ - gate voltage $V_G$ characteristics for three different trench power MOSFET devices at a drain voltage of 0.5 V. Curve A relates to $I_D$-$V_G$ characteristics of a first trench power MOSFET device according to the invention, curve B relates to $I_D$-$V_G$ characteristics of a second trench power MOSFET device according to the invention and curve C relates to $I_D$-$V_G$ characteristics of a trench power MOSFET device according to a comparative example having a configuration different from the invention. The two trench power MOSFET devices had a channel length of 0.2 $\mu$m and a channel thickness $t_{CH}$ of 50 nm, respectively. Curve A relates to a first power MOSFET device having a constant p-type doping concentration of $1 \cdot 10^{19}$ cm$^{-3}$ in the base layer and curve B relates to a second power MOSFET device having a constant p-type doping concentration of $1 \cdot 10^{18}$ cm$^{-3}$ in the base layer. Both, the first and the second power MOSFET device had a constant p-type doping concentration of $1 \cdot 10^{16}$ cm$^{-3}$ in the channel region. The power MOSFET device according to the comparative example did not have any lateral retrograde doping profile. Specifically in the power MOSFET device according to the comparative example has a constant p-type doping concentration of $1 \cdot 10^{17}$ cm$^{-3}$ in the base layer including a region directly adjacent to gate insulation layer.

As can be seen from Fig. 9 the $I_D$-$V_G$ characteristics of a trench power MOSFET device according to the comparative example (curve A) show a high subthreshold slope of about 250 mV/dec as a clear evidence of short channel effects. Moreover, the channel does not properly close in the comparative example. By implementing the lateral retrograde doping profile according to the invention with a relatively low doped channel region and a relatively high doped base layer as in the first and second power MOSFET device (curves A and B) a good off-state capability, optimum threshold voltage and a relatively low subthreshold slope of about 120 mV/dec can be achieved, which proves the effectiveness of the design according to the invention. Moreover, the threshold voltage can be controlled with the p-base acceptor concentration without degrading the electron mobility in the inversion channel.

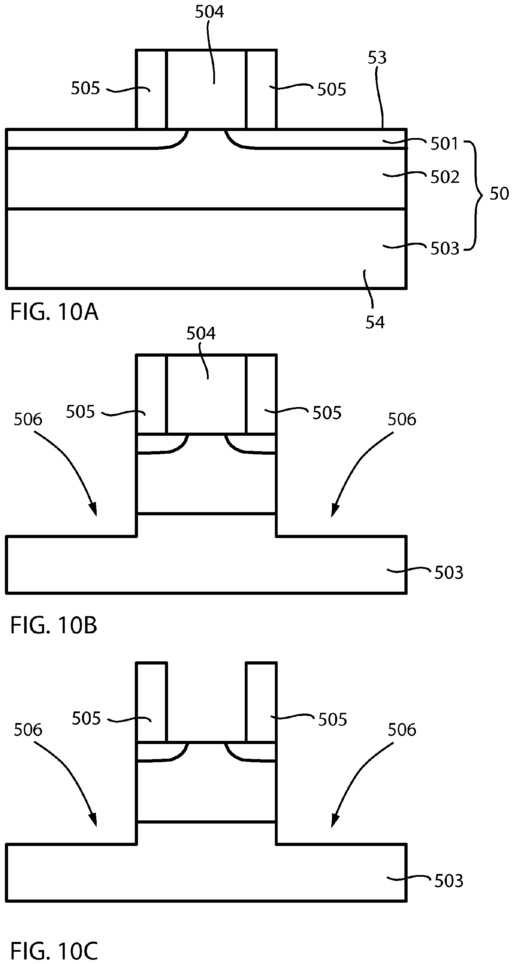

Referring to Figures 10A to 10F a first embodiment of a method for manufacturing a power semiconductor device according to the invention is described. Figures 10A to 10F show a partial cross-section of the device at different stages during the manufacturing method.

In a first method step a semiconductor wafer 50 as shown in Fig. 10A is provided. Exemplarily the semiconductor wafer 50 is a silicon carbide wafer. It has a first main side 53 and a second main side 54 opposite to the first main side 53. In an order from the first main side 53 to the second main side 54 the semiconductor wafer 50 includes an n$^+$-doped first semiconductor layer 501, a p-doped second semiconductor layer 502, and an n$^-$-doped third semiconductor layer 503. The semiconductor wafer 50 may include on its second main side 54 an n-doped drain layer (not shown in Figures 10A to 10G).

In a second method step a first mask pattern 504 is formed on the first main side 53 of the semiconductor wafer 50 as shown in Fig. 10A. The material of the first mask pattern 504 is exemplarily silicon oxide, photoresist, silicon nitride, aluminium (Al) or polysilicon. Next, as also shown in Fig. 10A, first side wall spacers 505 are formed at sidewalls of the first mask pattern 504. The material of the first side wall spacers 505 may exemplarily also be silicon oxide, photoresist, silicon nitride, aluminium (Al) or polysilicon. However, the material of the side wall spacers 505 has to be different from that of the first mask pattern 504 to have etch selectivity between these materials.

Thereafter, as shown in Fig. 10B, trenches 506 are etched into the semiconductor wafer 50 wherein the first mask pattern 504 and the first sidewall spacers 505 are used as an etching mask. The trenches 506 penetrate through the first semiconductor layer 501 and through the second semiconductor layer 502 into the third semiconductor layer 503.

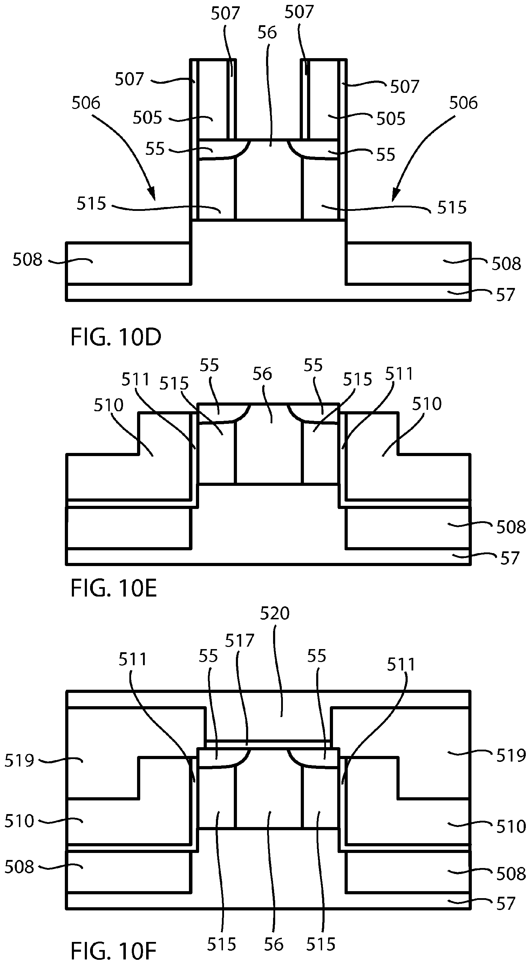

Next, as shown in Figs. 10C and 10D, the first mask pattern 504 is removed by selective etching to expose the semiconductor wafer 50 below the first mask pattern 504 and second side wall spacers 507 are formed on sidewalls of the first side wall spacers 505. Thereafter, a p-type first impurity is applied into the semiconductor wafer 50 using the first side wall spacers 505 and the second side wall spacers 507 as a doping mask to form a base layer 56 and channel regions 515 in the second semiconductor layer 502. The channel regions 515 are the remaining parts of the second semiconductor layer 502, i.e. the parts with unamended doping concentration, i.e. due to the additional application of a p impurity the base layer 56 has higher doping concentration than the channel regions 515. At the same time p-doped well regions 508 are formed below the trenches 506.

As shown in Fig. 10E, the doping mask including the first side wall spacers 505 and the second side wall spacers 507 is removed thereafter by selective etching. Next, an insulation layer is formed on a sidewall and a bottom of the trenches 506 to form a gate insulation layer 511. Therein, a mask may be used to form the gate insulation layer 511 only inside of the trenches 506 but not on other portions of the semiconductor wafer 50. Alternatively the insulation layer may first be formed on the whole device and may be patterned only thereafter.

Thereafter a conductive layer is formed on the insulation layer to form the electrically conductive gate electrode 510. Therein, a mask may be used to form the gate electrode 510 only inside of the trench 506 but not on other portions of the semiconductor wafer 50. The same mask as used for forming the gate insulation layer may be used. Alternatively the conductive layer may first be formed on the whole device and may be patterned only thereafter. The conductive layer may be patterned together with the insulation layer. The gate insulation layer 511 and the gate electrode 510 form gate structures for controlling conductivity in the channel regions 515.

As shown in Fig. 10F a top gate insulation layer 519 is formed to cover the gate electrodes 510. Thereafter, source electrodes 517 and a metallization layer 520 are formed to contact the source layer 55 and the base layer 56 through openings in the top gate insulation layer 519. Exemplarily, the source electrode 517 is a silicide layer.

The trench MOSFET device as shown in Fig. 10F is similar to the trench MOSFET device 100 as shown in Figures 1 and 2. It differs from the trench MOSFET device 100 only in that it comprises an additional p-type well 508 below the gate structures. Therefore, with regard to dimensions and doping concentration of all layers and regions it is referred to the description of the trench power MOSFET 100 above. Moreover, a drain layer and a drain electrode may be formed on the second main side 54 of the semiconductor wafer 50. The drain layer may be included in semiconductor wafer 50 as indicated above.

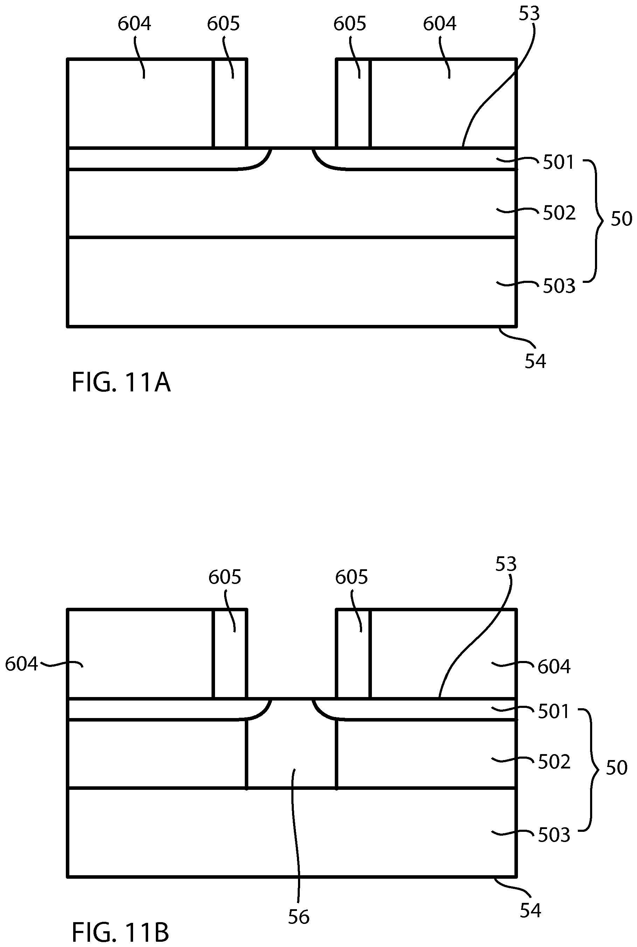

Referring to Figures 11A to 11F a second embodiment of a method for manufacturing a power semiconductor device according to the invention is described. Figures 11A to 11F show a partial cross-section of the device at different stages during the manufacturing method.

In a first method step a semiconductor wafer 50 as shown in Fig. 11A is provided. The semiconductor wafer 50 is the same as the semiconductor 50 described above with reference to Fig. 10A. It may also include an n-doped drain layer (not shown in Figures 11A to 11G).

In a second method step a first mask pattern 604 is formed on the first main side 53 of the semiconductor wafer 50 as shown in Fig. 11A. The material of the first mask pattern 604 is exemplarily silicon oxide, photoresist, silicon nitride, aluminium (Al) or polysilicon. Next, as also shown in Fig. 11A, first side wall spacers 605 are formed at sidewalls of the first mask pattern 604. The material of the first side wall spacers 605 may exemplarily also be silicon oxide, photoresist, silicon nitride, aluminium (Al) or polysilicon. However, the material of the side wall spacers 605 has to be different from that of the first mask pattern 604 to have etch selectivity between these materials.

Thereafter, a p-type first impurity is applied into the semiconductor wafer 50 using the first mask pattern 604 and the first side wall spacer 605 as a doping mask to form a base layer 56 and channel regions 515 in the second semiconductor layer 502.

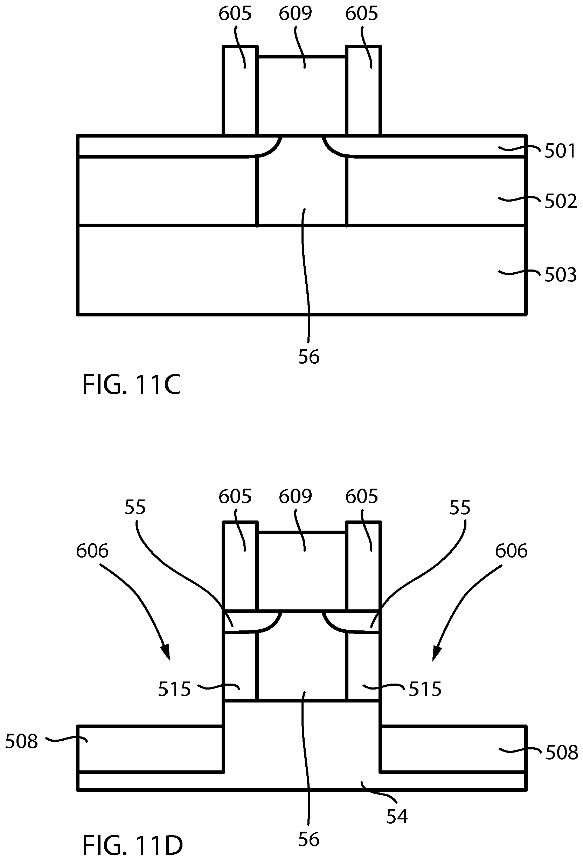

Thereafter, as shown in Fig. 11C, a second mask pattern 609 is formed in openings of the doping mask. As shown in Fig. 11D, trenches 606 are etched into the semiconductor wafer 50 wherein the second mask pattern 609 and the first sidewall spacers 605 are used as an etching mask. The trenches 606 penetrate through the first semiconductor layer 501 and through the second semiconductor layer 502 into the third semiconductor layer 503. The channel regions 515 are the remaining parts of the second semiconductor layer 502, i.e. the parts with unamended doping concentration, i.e. due to the additional application of a p impurity the base layer 56 has higher doping concentration than the channel regions 515.

After forming the trenches p-doped well regions 508 may be formed by selectively applying a p-type impurity through a bottom of the trenches 606 into the third semiconductor layer 503 using the second mask pattern 609 and the first sidewall spacers 605 as a doping mask as shown in Fig. 11D.

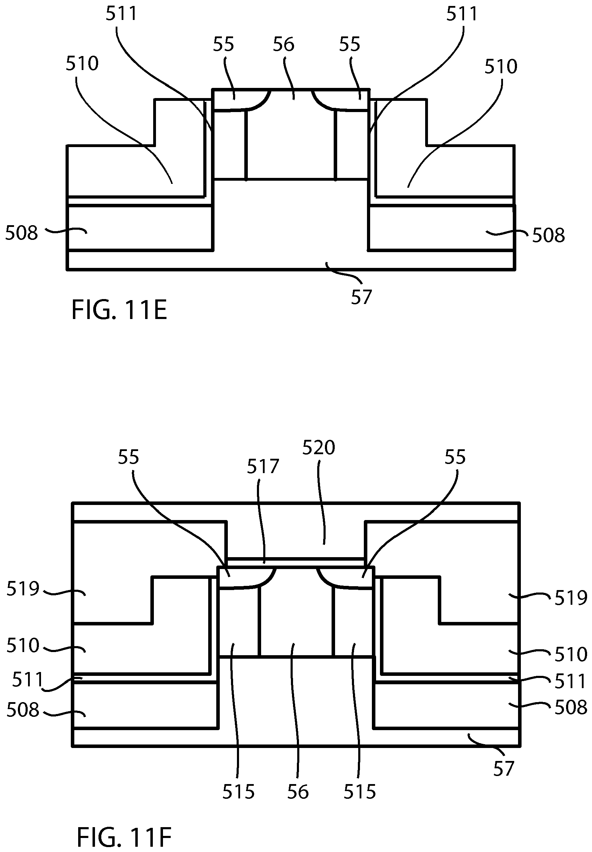

Thereafter, as shown in Fig. 11E gate structures including gate insulation layer 511 and gate electrodes 510 are formed in the trenches 606, and the second mask pattern 609 and the first side wall spacers 605 are removed by selective etching. Finally, the same steps as discussed above with regard to Fig. 10F are performed to form the structure as shown in Fig. 11F.

The trench MOSFET device as shown in Fig. 11F is similar to the trench MOSFET device 100 as shown in Figures 1 and 2. It differs from the trench MOSFET device 100 only in that it comprises an additional p-type well 508 below the gate structures. Therefore, with regard to dimensions and doping concentration of all layers and regions it is referred to the description of the trench power MOSFET 100 above. Moreover, a drain layer 8 and a drain electrode 18 may be formed on the second main side 54 of the semiconductor wafer 50 as in the trench power MOSFET shown in Fig. 1. The drain layer 8 may be included in semiconductor wafer 50 as indicated above.

The trench power MOSFET as shown in Fig. 10F is similar to the trench power MOSFET 100 as shown in Figures 1 and 2. It differs from the trench power MOSFET 100 only in that it comprises an additional p-type well 508 below the gate structures. Therefore, with regard to dimensions and doping concentration of all layers and regions it is referred to the description of the trench power MOSFET 100 above. Moreover, a drain layer 8 and a drain electrode 18 may be formed on the second main side 54 of the semiconductor wafer 50. The drain layer 8 may be included in semiconductor wafer 50 as indicated above.

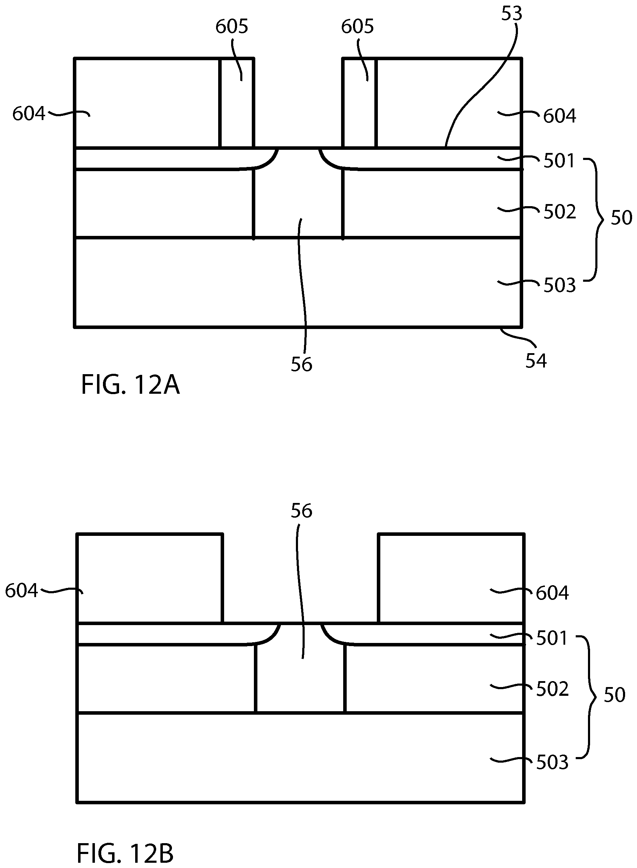

Referring to Figures 12A to 12F a third embodiment of a method for manufacturing a power semiconductor device according to the invention is described. Figures 12A to 12F show a partial cross-section of the device at different stages during the manufacturing method.

In a first method step a semiconductor wafer 50 as shown in Fig. 12A is provided. The semiconductor wafer 50 is the same as the semiconductor 50 described above with reference to Fig. 10A. It may also include an n-doped drain layer (not shown in Figures 12A to 12G).

In a second method step a first mask pattern 604 is formed on the first main side 53 of the semiconductor wafer 50 as shown in Fig. 12A. The material of the first mask pattern 604 is exemplarily silicon oxide, photoresist, silicon nitride, aluminium (Al) or polysilicon. Next, as also shown in Fig. 12A, first side wall spacers 605 are formed at sidewalls of the first mask pattern 604. The material of the first side wall spacers 605 may exemplarily also be silicon oxide, photoresist, silicon nitride, aluminium (Al) or polysilicon. However, the material of the side wall spacers 605 has to be different from that of the first mask pattern 604 to have etch selectivity between these two materials.

Thereafter, a p-type first impurity is applied into the semiconductor wafer 50 using the first mask pattern 604 and the first side wall spacers 605 as a doping mask to form a base layer 56 in the second semiconductor layer 502 as shown in Fig. 12A.

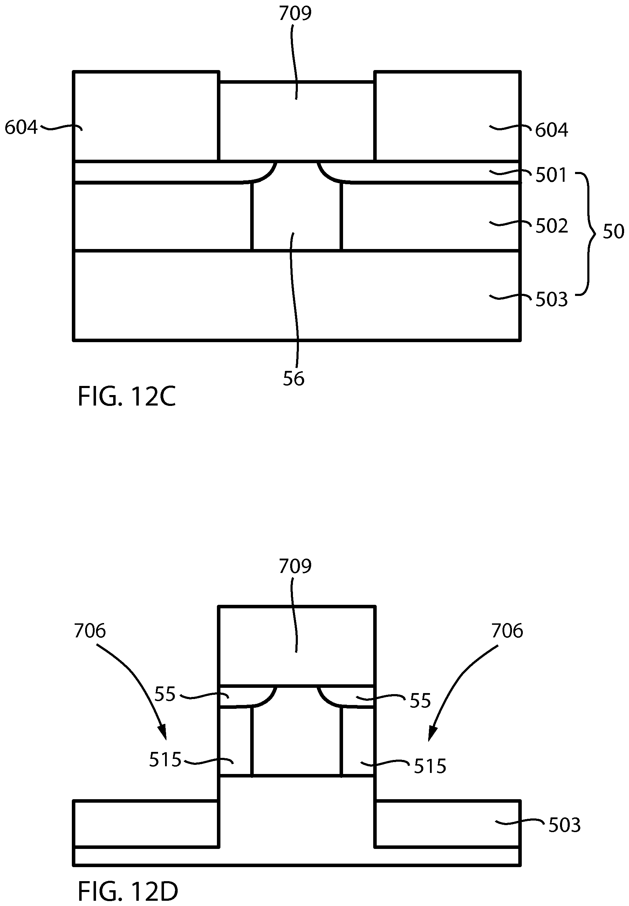

As shown in Fig. 12B, the first side wall spacers 605 are removed by selective etching and a second mask pattern 709 is formed in openings of the first mask pattern 604 as shown in Fig. 12C. Exemplarily a layer of the material of the second mask pattern 604 is formed on the whole structure and any material of this layer outside of the openings in the first mask pattern 604 is removed by planarization to form the second mask pattern 709.

Thereafter, the first mask pattern 604 is removed by selective etching. As shown in Fig. 12D, trenches 706 are etched into the semiconductor wafer 50 wherein the second mask pattern 709 is used as an etching mask. The trenches 706 penetrate through the first semiconductor layer 501 and through the second semiconductor layer 502 into the third semiconductor layer 503. After forming the trenches p-doped well regions 508 may be formed by selectively applying a p-type impurity through a bottom of the trenches 706 into the third semiconductor layer 503 using the second mask pattern 709 as a doping mask as shown in Fig. 12D.

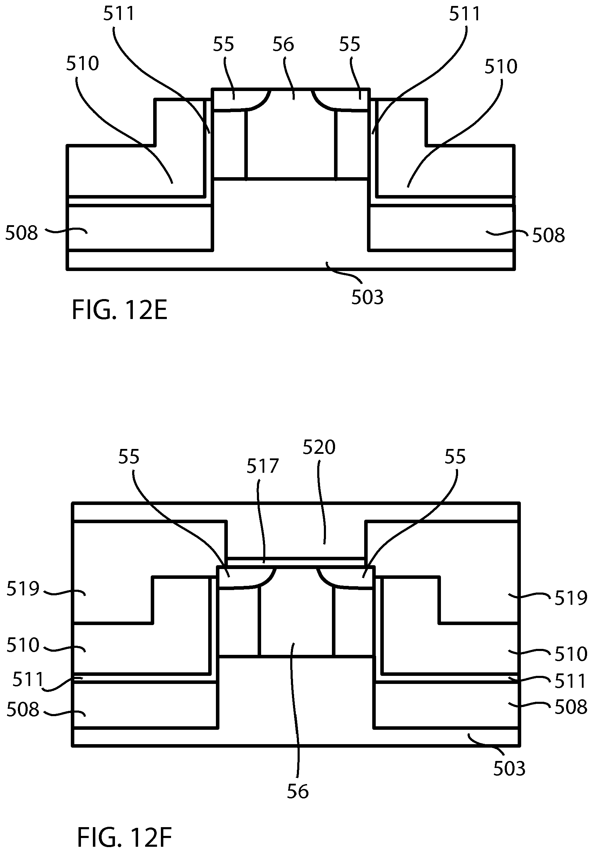

Thereafter, as shown in Fig. 12E gate structures including a gate insulation layer 511 and gate electrodes 510 are formed in the trenches 706 and the second mask pattern 709 is removed by selective etching. Finally, the same steps as discussed above with regard to Fig. 10F are performed to form the structure as shown in Fig. 12F.

The structure of the trench power MOSFET as shown in Fig. 12F is similar to the trench power MOSFET 100 as shown in Figures 1 and 2. It differs from the trench power MOSFET 100 only in that it comprises an additional p-type well 508 below the gate structures. Therefore, with regard to dimensions and doping concentration of all layers and regions it is referred to the description of the trench power MOSFET 100 above. Moreover, a drain layer 8 and a drain electrode 18 may be formed on the second main side 54 of the semiconductor wafer 50. The drain layer 8 may be included in semiconductor wafer 50 as indicated above.

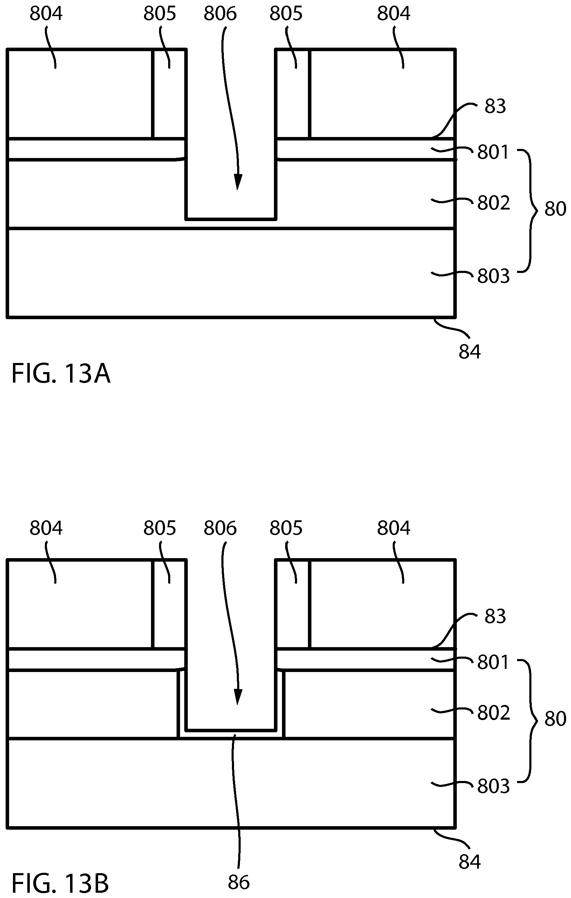

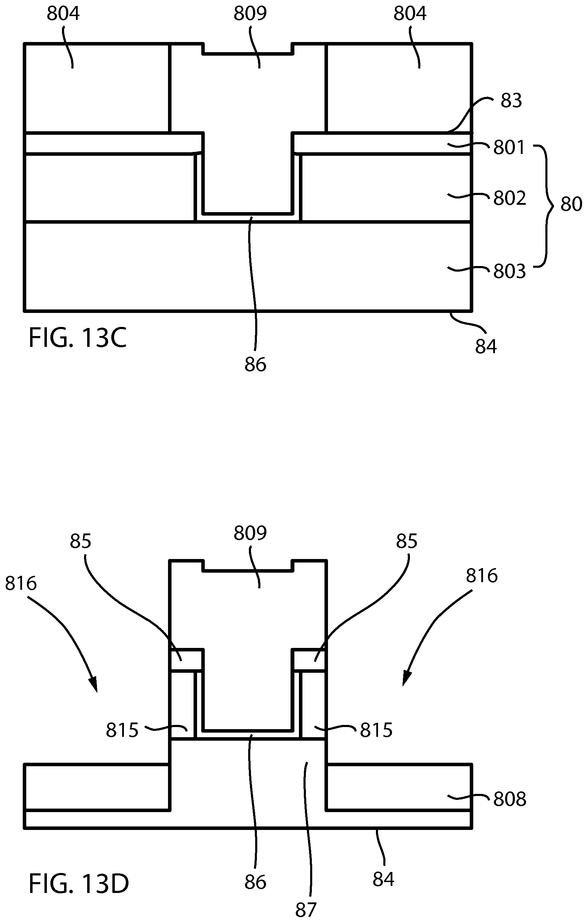

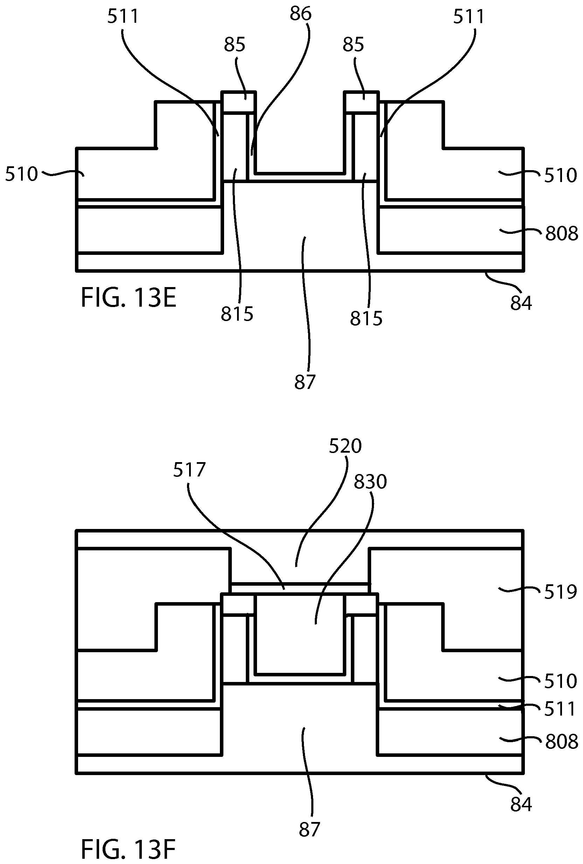

Referring to Figures 13A to 13F a fourth embodiment of a method for manufacturing a power semiconductor device according to the invention is described. Figures 13A to 13F show a partial cross-section of the device at different stages during the manufacturing method.

In a first method step a semiconductor wafer 80 is provided. Exemplarily the semiconductor wafer 80 is a silicon carbide (SiC) wafer. It has a first main side 83 and a second main side 84 opposite to the first main side 83. In an order from the first main side 83 to the second main side 84 the semiconductor wafer 80 includes an $n^+$-doped first semiconductor layer 801, a p-doped second semiconductor layer 802, and an $n^-$-doped third semiconductor layer 803. The semiconductor wafer 80 may include on its second main side 84 an n-doped drain layer (not shown in Figures 13A to 13G).

In a second method step a first mask pattern 804 is formed on the first main side 83 of the semiconductor wafer 80 as shown in Fig. 13A. The material of the first mask pattern 804 is exemplarily silicon oxide, photoresist, silicon nitride, aluminium (Al) or polysilicon. Next, as also shown in Fig. 13A, first side wall spacers 805 are formed at sidewalls of the first mask pattern 804. The material of the first side wall spacers 805 may exemplarily also be silicon oxide, photoresist, silicon nitride, aluminium (Al) or polysilicon. However, the material of the side wall spacers 805 has to be different from that of the first mask pattern 804 to have etch selectivity between these materials.

Thereafter, as also shown in Fig. 13A, first trenches 806 are etched into the semiconductor wafer 80, wherein the first mask pattern 804 and the first sidewall spacers 805 are used as an etching mask. The first trenches 806 penetrate through the first semiconductor layer 501 into the second semiconductor layer 502 close to an interface between the second semiconductor layer 802 and the third semiconductor layer 803. Exemplarily, the bottom is 100 nm or less from the interface between the second and third semiconductor layers 802 and 803.

Next, as shown in Fig. 13B, a p-type first impurity is applied into the semiconductor wafer 50 inside of the first trenches 806 using the first mask pattern and the first side wall spacers 805 as a doping mask to form a base layer 56 in the second semiconductor layer 502 through. Specifically, the p-type first impurity is applied through sidewalls and a bottom of first trenches 806, respectively, to form the base layer 86 at least in the second semiconductor layer 802. In exemplary embodiments applying the p-type first impurity into the sidewall and the bottom of the first trenches 806 is performed by angled ion implantation or by plasma immersion ion implantation (PIII). Plasma immersion ion implantation allows to form the base layer with a homogeneous doping concentration profile along a direction parallel to the sidewalls of the first trenches 816, i.e. a doping concentration profile, which is nearly independent from the depth (i.e. a distance from the first main side 83 of the semiconductor wafer 80).

As shown in Fig. 13C, first side wall spacers 805 are removed by selective etching and a second mask pattern 809 is formed inside of openings in the first mask pattern 804 and inside of first trenches 806. Thereafter, second trenches 816 are etched into the semiconductor wafer 80 wherein the second mask pattern 809 is used as an etching mask. The second trenches 816 penetrate through the first semiconductor layer 801 and the second semiconductor layer 802 into the third semiconductor layer 803. After forming the second trenches 816 p-doped well regions 508 may be formed by selectively applying a p-type impurity through a bottom of the second trenches 816 into the third semiconductor layer 803 using the second mask pattern 809 as a doping mask.

The second mask pattern 809 is removed thereafter and an insulation layer is formed on a sidewall and a bottom of the second trenches 816 to form a gate insulation layer 511. Therein, a mask may be used to form the gate insulation layer 811 only inside of the second trenches 816 but not on other portions of the semiconductor wafer 50.

Alternatively the insulation layer may first be formed on the whole device and may be patterned only thereafter.

Thereafter a conductive layer is formed on the gate insulation layer 511 to form the electrically conductive gate electrode 510. Therein, a mask may be used to form the gate electrode 510 only inside of the second trenches 816 but not on other portions of the semiconductor wafer 80. The same mask as used for forming the gate insulation layer 511 may be used. Alternatively the conductive layer may first be formed on the whole device and may be patterned only thereafter. The conductive layer may be patterned together with the insulation layer. The gate insulation layer 511 and the gate electrode 510 form gate structures for controlling conductivity in the channel regions 815.

As shown in Fig. 13F a top gate insulation layer 519 is formed to cover the gate electrodes 510, the first trenches 806 are filled with a conductive material 830, source electrodes are formed to electrically contact the source layer 85 and the base layer 815. Finally, a metallization layer 520 is formed on the source electrodes 517 and on the top gate insulation layer 519. Exemplarily, the source electrode 517 is a silicide layer.

The trench MOSFET device as shown in Fig. 13F is similar to the trench MOSFET device 300 as shown in Figures 5 and 6. It differs from the trench MOSFET device 300 only in that it comprises an additional p-type well 808 below the gate structures. Therefore, with regard to dimensions and doping concentration of all layers and regions it is referred to the description of the trench power MOSFET 300 above. Moreover, a drain layer and a drain electrode may be formed on the second main side 84 of the semiconductor wafer 80. The drain layer may be included in semiconductor wafer 50 as indicated above.

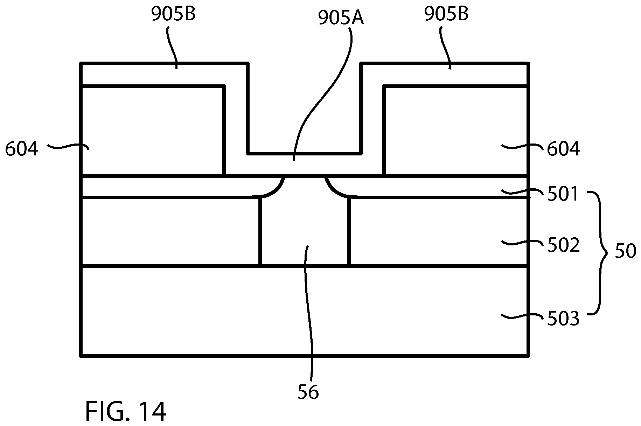

A modified second embodiment of a method for manufacturing a power semiconductor device according to the invention is described with reference to Fig. 14. The modified second embodiment differs from the second embodiment described with reference to Figures 11A to 11F only in that instead of side wall spacers 605 a thin masking layer 905 is used. The thickness of the masking layer 905 is thin enough to apply the first impurity through portion 905A of the masking layer 905, which is formed inside of openings in the first masking pattern 604, into the second semiconductor layer 502. The portions 905B on the sidewalls of the openings in the first masking pattern 604 have the same effect as sidewall spacers 605 in the second embodiment of a method for manufacturing a power semiconductor device according to the invention.

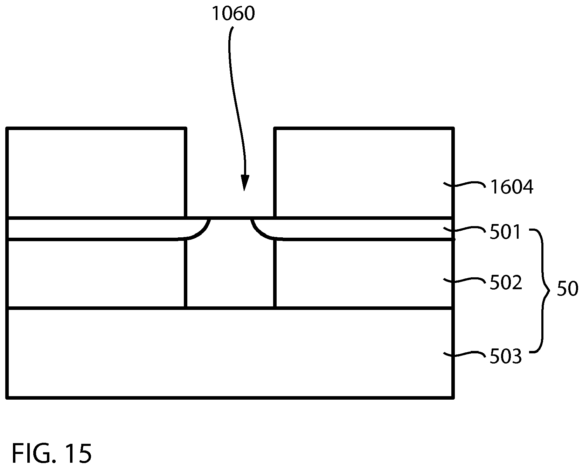

With reference to Fig. 15 a modified third embodiment of a method for manufacturing a power semiconductor device according to the invention is described. Instead of using the first mask pattern 604 and the sidewall spacers 605 as a doping mask, only first mask pattern 1604 is used as a doping mask. The structure shown in Fig. 12B is formed from the structure shown in Fig 15 by isotropic etching of a part of the first mask pattern 1604 to enlarge the opening 1060 in the first mask pattern 1604. All remaining method steps are the same as in the third embodiment of a method for manufacturing a power semiconductor device according to the invention.

In the description above, specific embodiments of the invention were described. However, alternatives and modifications of the above described embodiments are possible.

In the above described embodiments of a method for manufacturing a power semiconductor device according to the invention a p-doped well region 508 is formed below the gate structures for protecting the gate insulation layer 511 against high electric fields during operation of the power semiconductor device. However, in a modified embodiment of the method no p-doped well region 508 is formed below the gate structures. In the first embodiment of a method for manufacturing a power semiconductor device according to the invention the p-doped well regions 508 were formed together with the base layer 56. Accordingly, it would be necessary to use another mask layer to prevent forming of the p-doped well region during forming the base layer 56. E.g. the method described with reference to Figures 10A to 10F may be modified to manufacture trench power MOSFET 100 shown in Fig. 1, 2 by forming a second mask pattern on a bottom of the trench 506, wherein the second mask pattern is used as a part of the doping mask in the step of selectively applying the first impurity, and the second mask pattern is removed before the step of forming the insulation layer (11) on the sidewall of the trench (506).

In the above description trench power MOSFETs 100, 200, 300 and 400 were described as embodiments of the power semiconductor device of the invention. However, the invention is not limited to a trench power MOSFET. For example, another embodiment of the power semiconductor device of the invention is a trench insulated gate bipolartransistor (IGBT). Such trench IGBT differs from the trench power MOSFETs 100, 200, 300 and 400 described above by an additional p-doped layer on the second main side 4 of the semiconductor wafer 2.

In the above described first to third embodiments of a method for manufacturing a power semiconductor device according to the invention trenches 506, 606, and 706 penetrate through the first semiconductor layer 501 and through the second semiconductor layer 502 into the third semiconductor layer 503. In modified embodiments the trench 506, 606 and 706 may not extend into the third semiconductor layer 503. The same is true for second trenches 816 in the fourth embodiment of a method for manufacturing a power semiconductor device according to the invention.

The above embodiments were explained with specific conductivity types. The conductivity types of the semiconductor layers in the above described embodiments might be switched, so that in a specific embodiment all layers which were described as p-type layers would be n-type layers and all layers which were described as n-type layers would be p-type layers. For example, in a modified embodiment, the source layer 5 may be a p-doped layer, the base layer 6 may be an n-doped layer, and the substrate layer 9 may be a p-doped layer.

It should be noted that the term "comprising" does not exclude other elements or steps and that the indefinite article "a" or "an" does not exclude the plural. Also elements described in association with different embodiments may be combined.

List of reference signs

| | |
|---|---|
| 2, 50, 80 | semiconductor wafer |
| 3, 53, 83 | first main side |
| 4, 54, 84 | second main side |
| 5, 55, 85 | (n+-doped) source layer |
| 6, 26, 36, 46, 56, 86 | (p-doped) base layer |
| 7 | (n--doped) drift layer |
| 8 | (n+-doped) drain layer |
| 9 | (n-doped) substrate layer |
| 10 | gate electrode |
| 11 | gate insulation layer |
| 15 | (p-doped) channel region |
| 17, 517 | source electrode |
| 18 | drain electrode |
| 19 | top gate insulation layer |
| 20 | metallization layer |
| 32, 42 | base electrode region |
| 100, 200, 300, 400 | trench power MOSFET |
| 501, 801 | (n+-doped) first semiconductor layer |
| 502, 802 | (p-doped) second semiconductor layer |
| 503, 803 | (n-doped) third semiconductor layer |
| 504, 604, 804, 1604 | first mask pattern |
| 505, 605, 805 | first side wall spacer |
| 506, 606, 706 | trench |
| 507 | second side wall spacer |
| 508 | (p-type) well |
| 510 | gate electrode |
| 511 | gate insulation layer |
| 515 | channel region |
| 517 | source electrode |
| 519 | top gate insulation layer |
| 520 | metallization layer |
| 609, 709, 809 | second mask pattern |
| 806 | first trench |
| 815 | channel region |
| 816 | second trench |
| 830 | conductive material |
| 1060 | opening |
| $L_{CH}$ | channel length |
| $t_{CH}$ | thickness of the channel region |

**Claims**

1. A power semiconductor device comprising:

    a drift layer (7) having a first conductivity type;
    a base layer (6; 26; 36; 46) provided on the drift layer (7) and having a second conductivity type, which is different from the first conductivity type, the base layer (6; 26; 36; 46) forming a first p-n junction with the drift layer (7);
    a source layer (5) provided on the base layer (6; 26; 36; 46) and having the first conductivity type, the base layer (6; 26; 36; 46) forming a second p-n junction with the source layer (5);
a channel region (15) having the second conductivity type and extending from the source layer (5) to the drift layer (7), the channel region (15) forming a third p-n junction with the source layer (5) and a fourth p-n junction with the drift layer (7), and
a trench gate structure for controlling an electrical conductivity of the channel region (15), the trench gate structure including an electrically conductive gate electrode (10) and a gate insulation layer (11) electrically insulating the gate electrode (10) from the channel region (15),
wherein a first local doping concentration is less than $1 \cdot 10^{17}$ cm$^{-3}$ at all locations within the channel region (1), in the base layer (6; 26; 36; 46) a second local doping concentration is at least $1 \cdot 10^{17}$ cm$^{-3}$ at all locations within the base layer (6; 26; 36; 46),
the channel region (15) and the base layer (6; 26; 36; 46) are in direct contact with each other,
**characterized in that**

$$L_{CH} > 4\sqrt{\left(\frac{\varepsilon_{CH} t_{CH} t_{GI}}{\varepsilon_{GI}}\right)},$$

wherein $L_{CH}$ is a channel length, wherein the channel length $L_{CH}$ is defined as a length of a shortest path from the third p-n junction to the fourth p-n junction along an interface between the channel region (15) and the gate insulation layer (11), $\varepsilon_{CH}$ is a permittivity of the channel region (15), $\varepsilon_{GI}$ is a permittivity of the gate insulation layer (11), $t_{CH}$ is a thickness of the channel region (15) in a direction perpendicular to an interface between the gate insulation layer (11) and the channel region (15), and $t_{GI}$ is a thickness of the gate insulation layer (11) in a direction perpendicular to the interface between the gate insulation layer (11) and the channel region (15), wherein the mean value of the first local doping concentration in the channel region (15) is less than $4 \cdot 10^{16}$ cm$^{-3}$, and the thickness $t_{CH}$ of the channel region (15) is in a range from 1 nm to 10 nm.

2. The power semiconductor device according to claim 1, wherein the thickness $t_{CH}$ of the channel region (15) is in a range from 2 nm to 5 nm.

3. The power semiconductor device according to claim 1 or 2, wherein the channel length $L_{CH}$ is less than 0.6 $\mu$m, or less than 0.5 $\mu$m, or less than 0.4 $\mu$m, or less than 0.3 $\mu$m.

4. The power semiconductor device according to anyone of claims 1 to 3, wherein the mean value of the first local doping concentration in the channel region (15) is less than $2 \cdot 10^{16}$ cm$^{-3}$.

5. The power semiconductor device according to anyone of claims 1 to 4, wherein a mean value of the second local doping concentration in the base layer (6; 26; 36; 46) is at least $5 \cdot 10^{17}$ cm$^{-3}$ or at least $1 \cdot 10^{18}$ cm$^{-3}$ or at least $5 \cdot 10^{18}$ cm$^{-3}$.

6. The power semiconductor device according to anyone of claims 1 to 5, wherein a depth of the base layer (26; 46) is larger than the depth of the channel region (15).

7. The power semiconductor device according to anyone of claims 1 to 6, wherein a base electrode region (32; 42) penetrates into the base layer (36; 46) to form a trench contact to the base layer (36; 46).

8. The power semiconductor device according to anyone of claims 1 to 7, wherein a gradient of the local doping concentration at an interface between the channel region (15) and the base layer (6; 26; 36; 46) is at least $10^{16}$ cm$^{-3}$/nm.

9. A method for manufacturing a power semiconductor device according to anyone of claims 1 to 8, the method comprising the following steps:

providing a semiconductor wafer (50), the semiconductor wafer (50) including in an order from a first main side (53) of the semiconductor wafer (50) to a second main side (54) of the semiconductor wafer (50) a first semiconductor layer (501) of the first conductivity type, a second semiconductor layer (502) of the second conductivity type, and a third semiconductor layer (503) of the first conductivity type, wherein the first semiconductor layer (501) forms the source layer (55) in the power semiconductor device (100) and wherein the third semiconductor layer (503) forms the drift layer (57) in the power semiconductor device (100);

forming a first mask pattern (504) on the first main side (53) of the semiconductor wafer (50);

forming a first side wall spacer (505) at a sidewall of the first mask pattern (504);

etching the first and the second semiconductor layer (501, 502) to form a trench (506) in the first and second semiconductor layer (501, 502), wherein the first mask pattern (504) and the first sidewall spacer (505) are used as an etching mask;

selectively etching the first mask pattern (504) after forming the trench (506) to expose the semiconductor wafer (50) below the first mask pattern (504);

forming a second side wall spacer (507) on a sidewall of the first side wall spacer (505) after the step of selectively etching the first mask pattern (504) selectively applying a first impurity of the second conductivity type into the semiconductor wafer (50) using the first side wall spacer (505) and the second side wall spacer (507) at least as a part of a doping mask to form the base layer (56) and the channel region (515) in the second semiconductor layer (502);

removing the doping mask including the first side wall spacer (505) and the second side wall spacer (507);

forming an insulation layer on a sidewall and a bottom of the trench (506) to form the gate insulation layer (511); and

forming a conductive layer on the insulation layer to form the electrically conductive gate electrode (510).

10. The method according to claim 9, comprising a step of forming a second mask pattern on a bottom of the trench (506), wherein

the second mask pattern is used as a part of the doping mask in the step of selectively applying the first impurity, and the second mask pattern is removed before the step of forming the insulation layer (11) on the sidewall of the trench (506).

11. A method for manufacturing a power semiconductor device according to anyone of claims 1 to 8, the method comprising the following steps:

providing a semiconductor wafer (50; 80), the semiconductor wafer (50; 80) including in an order from a first main side (53; 83) of the semiconductor wafer (50; 80) to a second main side (54; 84) of the semiconductor wafer (50; 80) a first semiconductor layer (501; 801) of the first conductivity type, a second semiconductor layer (502; 802) of the second conductivity type, and a third semiconductor layer (503; 803) of the first conductivity type, wherein the first semiconductor layer (501; 801) forms the source layer (55; 85) in the power semiconductor device (100; 200; 300; 400) and wherein the third semiconductor layer (503; 803) forms the drift layer (57; 87) in the power semiconductor device (100; 200; 300; 400);

forming a first mask pattern (604, 605; 804, 805; 604, 905; 1604) on the first main side (53; 83) of the semiconductor wafer (50; 80), wherein the first mask pattern (604, 605; 804, 805; 604, 905; 1604) has an opening;

selectively applying a first impurity of the second conductivity type through the first opening into the semiconductor wafer (50; 80) using the first mask pattern (604, 605; 804, 805; 604, 905; 1604) as a first doping mask to form the base layer (56; 86) and the channel region (515; 815) in the second semiconductor layer (502; 802);

removing a part of the first mask pattern (604, 605; 804, 805; 604, 905; 1604) to enlarge the first opening in the first mask pattern (604, 605; 804, 805; 604, 905; 1604);

forming a second mask pattern (709; 809) in the enlarged first opening of the remaining first mask pattern (604; 804);

selectively etching the remaining first mask pattern (604; 804) to expose the semiconductor wafer (50; 80) below the remaining first mask pattern (604; 804);

etching the first and the second semiconductor layer (501, 502; 801, 802) to form a first trench (506; 816) in the first and second semiconductor layer (501, 502; 801, 802), wherein the second mask pattern (709; 809) is used as an etching mask;

removing the second mask pattern (709; 809);

forming an insulation layer on a sidewall and a bottom of the first trench to form the gate insulation layer (511); and

forming a conductive layer on the insulation layer to form the electrically conductive gate electrode (510).

12. The method according to claim 11, wherein the step of forming a first mask pattern on the first main side (53; 83) of the semiconductor wafer (50; 80) comprises:

a step of forming a first mask portion (604; 804, 805) including a second opening, and

a step of forming a second mask portion (605; 905; 805) at least on a sidewall of the second opening to form the first mask pattern (604, 605; 604, 905; 804, 805) including the first and second mask portions; and

wherein the step of removing the part of the first mask pattern (604, 605; 804, 805; 604, 905) to enlarge the first opening in the first mask pattern (604, 605; 804, 805; 604, 905) is performed by selectively etching the second mask portion (605; 805; 905).

13. The method according to claim 11 or 12, comprising a step of forming a second trench (806) before the step of selectively applying the first impurity, wherein the first mask pattern (804, 805) is used as an etching mask during the step forming the second trench (806).

14. The method according to anyone of claims 11 to 13, comprising a step of selectively applying a second impurity of the second conductivity type into the semiconductor wafer (80) through the bottom of the first trench (806), wherein the second mask pattern (809) is used as a second doping mask.

**Patentansprüche**

1. Leistungshalbleiterbauelement, umfassend:

eine Driftschicht (7) mit einem ersten Leitfähigkeitstyp;
eine Basisschicht (6; 26; 36; 46), die auf der Driftschicht (7) vorgesehen ist und einen zweiten Leitfähigkeitstyp aufweist, der vom ersten Leitfähigkeitstyp verschieden ist, wobei die Basisschicht (6; 26; 36; 46) einen ersten p-n-Übergang mit der Driftschicht (7) bildet;
eine Source-Schicht (5), die auf der Basisschicht (6; 26; 36; 46) vorgesehen ist und den ersten Leitfähigkeitstyp aufweist, wobei die Basisschicht (6; 26; 36; 46) einen zweiten p-n-Übergang mit der Source-Schicht (5) bildet;
eine Kanalregion (15), die den zweiten Leitfähigkeitstyp aufweist und sich von der Source-Schicht (5) zur Driftschicht (7) erstreckt, wobei die Kanalregion (15) einen dritten p-n-Übergang mit der Source-Schicht (5) und einen vierten p-n-Übergang mit der Driftschicht (7) bildet, und
eine Graben-Gate-Struktur zum Steuern einer elektrischen Leitfähigkeit der Kanalregion (15), wobei die Graben-Gate-Struktur eine elektrisch leitende Gate-Elektrode (10) und eine Gate-Isolierschicht (11) umfasst, welche die Gate-Elektrode (10) elektrisch von der Kanalregion (15) isoliert,
wobei eine erste lokale Dotierungskonzentration an allen Stellen innerhalb der Kanalregion (15) weniger als $1 \cdot 10^{17}$ cm$^{-3}$ beträgt,
eine zweite lokale Dotierungskonzentration in der Basisschicht (6; 26; 36; 46) an allen Stellen innerhalb der Basisschicht (6; 26; 36; 46) mindestens $1 \cdot 10^{17}$ cm$^{-3}$ beträgt,
die Kanalregion (15) und die Basisschicht (6; 26; 36; 46) in direktem Kontakt miteinander sind,
**dadurch gekennzeichnet, dass**

$$L_{CH} > 4\sqrt{\left(\frac{\varepsilon_{CH} t_{CH} t_{GI}}{\varepsilon_{GI}}\right)},$$

wobei $L_{CH}$ eine Kanallänge ist, wobei die Kanallänge $L_{CH}$ als eine Länge eines kürzesten Wegs vom dritten p-n-Übergang zum vierten p-n-Übergang entlang einer Grenzfläche der Kanalregion (15) und der Gate-Isolierschicht (11) definiert ist, $E_{CH}$ eine Dielektrizitätskonstante der Kanalregion (15) ist, $E_{GI}$ eine Dielektrizitätskonstante der Gate-Isolierschicht (11) ist, $t_{CH}$ eine Dicke der Kanalregion (15) in einer Richtung senkrecht zu einer Grenzfläche zwischen der Gate-Isolierschicht (11) und der Kanalregion (15) ist, und $t_{GI}$ eine Dicke der Gate-Isolierschicht (11) in einer Richtung senkrecht zur Grenzfläche zwischen der Gate-Isolierschicht (11) und der Kanalregion (15) ist, wobei
der Mittelwert der ersten lokalen Dotierungskonzentration in der Kanalregion (15) weniger als $4 \cdot 10^{16}$ cm$^{-3}$ beträgt, und
die Dicke $t_{CH}$ der Kanalregion (15) in einem Bereich von 1 nm bis 10 nm liegt.

2. Leistungshalbleiterbauelement nach Anspruch 1, **dadurch gekennzeichnet, dass** die Dicke $t_{CH}$ der Kanalregion (15) im Bereich von 2 nm bis 5 nm liegt.

3. Leistungshalbleiterbauelement nach Anspruch 1 oder 2, wobei die Kanallänge $L_{CH}$ weniger als 0,6 μm oder weniger als 0,5 μm oder weniger als 0,4 μm oder weniger als 0,3 μm beträgt.

4. Leistungshalbleiterbauelement nach einem der Ansprüche 1 bis 3, wobei der Mittelwert der ersten lokalen Dotierungskonzentration in der Kanalregion (15) weniger als $2\cdot10^{16}$ cm$^{-3}$ beträgt.

5. Leistungshalbleiterbauelement nach einem der Ansprüche 1 bis 4, wobei ein Mittelwert der zweiten lokalen Dotierungskonzentration in der Basisschicht (6; 26; 36; 46) mindestens $5\cdot10^{17}$ cm$^{-3}$ oder mindestens $1\cdot10^{18}$ cm$^{-3}$ oder mindestens $5\cdot10^{18}$ cm$^{-3}$ beträgt.

6. Leistungshalbleiterbauelement nach einem der Ansprüche 1 bis 5, wobei eine Tiefe der Basisschicht (26; 46) größer als die Tiefe der Kanalregion (15) ist.

7. Leistungshalbleiterbauelement nach einem der Ansprüche 1 bis 6, wobei eine Basiselektrodenregion (32; 42) in die Basisschicht (36; 46) eindringt, um einen Grabenkontakt mit der Basisschicht (36; 46) zu bilden.

8. Leistungshalbleiterbauelement nach einem der Ansprüche 1 bis 7, wobei ein Gradient der lokalen Dotierungskonzentration an einer Grenzfläche zwischen der Kanalregion (15) und der Basisschicht (6; 26; 36; 46) mindestens $10^{16}$ cm$^{-3}$/nm beträgt.

9. Verfahren zur Herstellung eines Leistungshalbleiterbauelements nach einem der Ansprüche 1 bis 8, wobei das Verfahren die folgenden Schritte umfasst:

   Bereitstellen eines Halbleiterwafers (50), wobei der Halbleiterwafer (50) in einer Reihenfolge von einer ersten Hauptseite (53) des Halbleiterwafers (50) zu einer zweiten Hauptseite (54) des Halbleiterwafers (50) eine erste Halbleiterschicht (501) des ersten Leitfähigkeitstyps, eine zweite Halbleiterschicht (502) des zweiten Leitfähigkeitstyps und eine dritte Halbleiterschicht (503) des ersten Leitfähigkeitstyps umfasst, wobei die erste Halbleiterschicht (501) die Source-Schicht (55) im Leistungshalbleiterbauelement (100) bildet, und wobei die dritte Halbleiterschicht (503) die Driftschicht (57) im Leistungshalbleiterbauelement (100) bildet;
   Bilden einer ersten Maskenstruktur (504) auf der ersten Hauptseite (53) des Halbleiterwafers (50);
   Bilden einer ersten Seitenwandabstandsschicht (505) an einer Seitenwand der ersten Maskenstruktur (504);
   Ätzen der ersten und der zweiten Halbleiterschicht (501, 502), um einen Graben (506) in der ersten und der zweiten Halbleiterschicht (501, 502) zu bilden, wobei die erste Maskenstruktur (504) und die erste Seitenwandabstandsschicht (505) als eine Ätzmaske verwendet werden;
   selektives Ätzen der ersten Maskenstruktur (504) nach dem Bilden des Grabens (506), um den Halbleiterwafer (50) unter der ersten Maskenstruktur (504) freizulegen;
   Bilden einer zweiten Seitenwandabstandsschicht (507) auf einer Seitenwand der ersten Seitenwandabstandsschicht (505) nach dem Schritt des selektiven Ätzens der ersten Maskenstruktur (504):

      selektives Einbringen einer ersten Verunreinigung des zweiten Leitfähigkeitstyps in den Halbleiterwafer (50) unter Verwendung der ersten Seitenwandabstandsschicht (505) und der zweiten Seitenwandabstandsschicht (507) wenigstens als einen Teil einer Dotierungsmaske, um die Basisschicht (56) und die Kanalregion (515) in der zweiten Halbleiterschicht (502) zu bilden;
      Entfernen der Dotierungsmaske, welche die ersten Seitenwandabstandsschicht (505) und die zweite Seitenwandabstandsschicht (507) umfasst;
      Bilden einer Isolierschicht auf einer Seitenwand und einem Boden des Grabens (506), um die Gate-Isolierschicht (511) zu bilden; und
      Bilden einer leitenden Schicht auf der Isolierschicht, um die elektrisch leitende Gate-Elektrode (510) zu bilden.

10. Verfahren nach Anspruch 9,. umfassend einen Schritt des Bildens einer zweiten Maskenstruktur auf einem Boden des Grabens (506), wobei
    die zweite Maskenstruktur als ein Teil der Dotierungsmaske im Schritt des selektiven Einbringens der ersten Verunreinigung verwendet wird, und
    die zweite Maskenstruktur vor dem Schritt des Bildens der Isolierschicht (11) auf der Seitenwand des Grabens (506) entfernt wird.

11. Verfahren zur Herstellung eines Leistungshalbleiterbauelements nach einem der Ansprüche 1 bis 8, wobei das Verfahren die folgenden Schritte umfasst:

    Bereitstellen eines Halbleiterwafers (50; 80), wobei der Halbleiterwafer (50; 80) in einer Reihenfolge von einer ersten Hauptseite (53; 83) des Halbleiterwafers (50; 80) zu einer zweiten Hauptseite (54; 84) des Halbleiterwafers (50; 80) eine erste Halbleiterschicht (501; 801) des ersten Leitfähigkeitstyps, eine zweite Halbleiterschicht (502; 802) des zweiten Leitfähigkeitstyps und eine dritte Halbleiterschicht (503; 803) des ersten Leitfähigkeitstyps umfasst, wobei die erste Halbleiterschicht (501; 801) die Source-Schicht (55; 85) im Leistungshalbleiterbauelement (100; 200; 300; 400) bildet, und wobei die dritte Halbleiterschicht (503; 803) die Driftschicht (57; 87) im Leistungshalbleiterbauelement (100; 200; 300; 400) bildet;

Bilden einer ersten Maskenstruktur (604, 605; 804, 805; 604, 905; 1604) auf der ersten Hauptseite (53; 83) des Halbleiterwafers (50; 80), wobei die erste Maskenstruktur (604, 605; 804, 805; 604, 905; 1604) eine Öffnung aufweist;

selektives Einbringen einer ersten Verunreinigung des zweiten Leitfähigkeitstyps durch die erste Öffnung in den Halbleiterwafer (50; 80) unter Verwendung der ersten Maskenstruktur (604, 605; 804, 805; 604, 905; 1604) als einer ersten Dotierungsmaske, um die Basisschicht (56; 86) und die Kanalregion (515; 815) in der zweiten Halbleiterschicht (502; 802) zu bilden;

Entfernen eines Teils der ersten Maskenstruktur (604, 605; 804, 805; 604, 905; 1604), um die erste Öffnung in der ersten Maskenstruktur (604, 605; 804, 805; 604, 905; 1604) zu vergrößern;

Bilden einer zweiten Maskenstruktur (709; 809) in der vergrößerten ersten Öffnung der restlichen ersten Maskenstruktur (604; 804);

selektives Ätzen der restlichen ersten Maskenstruktur (604; 804), um den Halbleiterwafer (50; 80) unter der restlichen ersten Maskenstruktur (604; 804) freizulegen;

Ätzen der ersten und der zweiten Halbleiterschicht (501, 502; 801, 802), um einen ersten Graben (506; 816) in der ersten und der zweiten Halbleiterschicht (501, 502; 801, 802) zu bilden, wobei die zwei Maskenstruktur (709; 809) als eine Ätzmaske verwendet wird;

Entfernen der zweiten Maskenstruktur (709; 809);

Bilden einer Isolierschicht auf einer Seitenwand und einem Boden des ersten Grabens, um die Gate-Isolierschicht (511) zu bilden; und

Bilden einer leitenden Schicht auf der Isolierschicht, um die elektrisch leitende Gate-Elektrode (510) zu bilden.

**12.** Verfahren nach Anspruch 11, wobei der Schritt des Bildens einer ersten Maskenstruktur auf der ersten Hauptseite (53; 83) des Halbleiterwafers (50; 80) umfasst:

einen Schritt des Bildens eines ersten Maskenabschnitts (604; 804, 805), der eine zweite Öffnung umfasst, und einen Schritt des Bildens eines zweiten Maskenabschnitts (605; 905; 805) an mindestens einer Seitenwand der zweiten Öffnung, um die erste Maskenstruktur (604, 605; 604, 905; 804, 805) zu bilden, die den ersten und den zweiten Maskenabschnitt umfasst; und

wobei der Schritt des Entfernen des Teils der ersten Maskenstruktur (604, 605; 804, 805; 604, 905) zum Vergrößern der ersten Öffnung in der ersten Maskenstruktur (604, 605; 804, 805; 604, 905) durch selektives Ätzen des zweiten Maskenabschnitts (605; 805; 905) ausgeführt wird.

**13.** Verfahren nach Anspruch 11 oder 12, umfassend einen Schritt des Bildens eines zweiten Grabens (806) vor dem Schritt des selektiven Einbringens der ersten Verunreinigung, wobei die erste Maskenstruktur (804, 805) während des Schritts des Bildens des zweiten Grabens (806) als eine Ätzmaske verwendet wird.

**14.** Verfahren nach einem der Ansprüche 11 bis 13, umfassend einen Schritt des selektiven Einbringens einer zweiten Verunreinigung des zweiten Leitfähigkeitstyps in den Halbleiterwafer (80) durch den Boden des ersten Grabens (806), wobei die zweite Maskenstruktur (809) als eine zweite Dotierungsmaske verwendet wird.

**Revendications**

**1.** Dispositif semi-conducteur de puissance comprenant :

une couche de dérive (7) ayant un premier type de conductivité ;
une couche de base (6 ; 26 ; 36 ; 46) prévue sur la couche de dérive (7) et ayant un deuxième type de conductivité, qui est différent du premier type de conductivité, cette couche de base (6 ; 26 ; 36 ; 46) formant une jonction p-n avec la couche de dérive (7) ;
une couche de source (5) prévue sur la couche de base (6 ; 26 ; 36 ; 46) et ayant un premier type de conductivité, la couche de base (6 ; 26 ; 36 ; 46) formant une deuxième jonction p-n avec la couche de source (5) ;
une région canal (15) ayant le deuxième type de conductivité et s'étendant de la couche de source (5) à la couche de dérive (7), cette région canal (15) formant une troisième jonction p-n avec la couche de source (5) et une quatrième jonction p-n avec la couche de dérive (7), et

une structure à grille de tranchée pour commander une conductivité électrique de la région canal (15), cette structure à grille de tranchée comprenant une électrode de grille électriquement conductrice (10) et une couche d'isolation de grille (11) isolant électriquement l'électrode de grille (10) de la région canal (15),

une première concentration de dopage locale étant moins que $1 \cdot 10^{17}$ cm$^{-3}$ à tous les emplacements à l'intérieur de la région canal (15),

dans la couche de base (6 ; 26 ; 36 ; 46), une deuxième concentration de dopage locale étant au moins $1 \cdot 10^{17}$ cm$^{-3}$ à tous les emplacements à l'intérieur de la couche de base (6 ; 26 ; 36 ; 46),

la région canal (15) et la couche de base (6 ; 26 ; 36 ; 46) étant en contact direct l'une avec l'autre, **caractérisé en ce que**

$$L_{CH} > 4\sqrt{\left(\frac{\varepsilon_{CH} t_{CH} t_{GI}}{\varepsilon_{GI}}\right)},$$

équation dans laquelle $L_{CH}$ est une longueur de canal, cette longueur de canal $L_{CH}$ étant définie comme une longueur d'un trajet le plus court entre la troisième jonction p-n et la quatrième jonction p-n le long d'une interface entre la région canal (15) et la couche d'isolation de la grille (11), $\varepsilon_{CH}$ est une permittivité de la région canal (15), $\varepsilon_{GI}$ est une permittivité de la couche d'isolation de la grille (11), $t_{CH}$ est une épaisseur de la région canal (15) dans une direction perpendiculaire à une interface entre la couche d'isolation de la grille (11) et la région canal (15), et $t_{GI}$ est une épaisseur de la couche d'isolation de la grille (11) dans une direction perpendiculaire à l'interface entre la couche d'isolation de la grille (11) et la région canal (15),

la valeur moyenne de la première concentration de dopage locale dans la région canal (15) étant moins que $4 \cdot 10^{16}$ cm$^{-3}$, et

l'épaisseur $t_{CH}$ de la région canal (15) étant située dans une plage allant de 1 nm 10 nm.

2. Dispositif semi-conducteur de puissance selon la revendication 1, dans lequel l'épaisseur $t_{CH}$ de la région canal (15) est située dans une plage allant de 2 nm à 5 nm.

3. Dispositif semi-conducteur de puissance selon la revendication 1 ou 2, dans lequel la longueur du canal $L_{CH}$ est moins que 0,6 μm, ou moins que 0,5 μm, ou mins que 0,4 μm, ou moins que 0,3 pm.

4. Dispositif semi-conducteur de puissance selon l'une quelconque des revendications 1 à 3, dans lequel la valeur moyenne de la première concentration de dopage locale dans la région canal (15) est moins que $2 \cdot 10^{16}$ cm$^{-3}$.

5. Dispositif semi-conducteur de puissance selon l'une quelconque des revendications 1 à 4, dans lequel une valeur moyenne de la deuxième concentration de dopage locale dans la couche de base (6 ; 26 ; 36 ; 46) est au moins $5 \cdot 10^{17}$ cm$^{-3}$ ou au moins $1 \cdot 10^{18}$ cm$^{-3}$ ou au moins $5 \cdot 10^{18}$ cm$^{-3}$.

6. Dispositif semi-conducteur de puissance selon l'une quelconque des revendications 1 à 5, dans lequel une profondeur de la couche de base (26 ; 46) est plus grande que la profondeur de la région canal (15).

7. Dispositif semi-conducteur de puissance selon l'une quelconque des revendications 1 à 6, dans lequel une région électrode de base (32 ; 42) pénètre dans la couche de base (36 ; 46) afin de former un contact de tranchée jusqu'à la couche de base (36 ; 46).

8. Dispositif semi-conducteur de puissance selon l'une quelconque des revendications 1 à 7, dans lequel une pente de la concentration de dopage locale au niveau d'une interface entre la région canal (15) et la couche de base (6 ; 26 ; 36 ; 46) est au moins $10^{16}$ cm$^{-3}$/nm.

9. Procédé de fabrication d'un dispositif semi-conducteur de puissance selon l'une quelconque des revendications 1 à 8, ce procédé comprenant les étapes suivantes :

la prévision d'une tranche de semi-conducteur (50), cette tranche de semi-conducteur (50) comprenant, dans un ordre allant d'un premier côté principal (53) de la tranche de semi-conducteur (50) à un deuxième côté principal (54) de la tranche de semi-conducteur (50), une première couche semi-conductrice (501) du premier type de conductivité, une deuxième couche semi-conductrice (502) du deuxième type de conductivité, et une troisième couche semi-conductrice (503) du premier type de conductivité, la première couche semi-conductrice (501) formant la couche de source (55) dans le dispositif semiconducteur de puissance (100) et la troisième couche semi-conductrice (503) formant la couche de dérive (57) dans le dispositif semiconducteur de puissance (100) ;

la formation d'un premier dessin de masques (504) sur le premier côté principal (53) de la tranche de semi-conducteur (50) ;

la formation d'une première entretoise de paroi latérale (505) au niveau d'une paroi latérale du premier dessin de masques (504) ;

la gravure de la première et de la deuxième couche semi-conductrice (501, 502) afin de former une tranchée (506) dans la première et la deuxième couche semi-conductrice (501, 502), le premier dessin de masques (504) et la première entretoise de paroi latérale (505) étant utilisés comme un masque de gravure ;

la gravure sélective du premier dessin de masques (504) après la formation de la tranchée (506) afin d'exposer la tranche de semi-conducteur (50) en dessous de premier dessin de masques (504) ;

la formation d'une deuxième entretoise de paroi latérale (507) sur une paroi latérale de la première entretoise de paroi latérale (505) après l'étape de gravure sélective du premier dessin de masques (504) ;

l'application sélective d'une première impureté du deuxième type de conductivité dans la tranche de semi-conducteur (50) en utilisant la première entretoise de paroi latérale (505) et la deuxième entretoise de paroi latérale (507) au moins comme faisant partie d'un masque de dopage pour former la couche de base (56) et la région canal (515) dans la deuxième couche semi-conductrice (502) ;

l'enlèvement du masque de dopage comprenant la première entretoise de paroi latérale (505) et la deuxième entretoise de paroi latérale (507) ;

la formation d'une couche d'isolation sur une paroi latérale et un fond de la tranchée (506) afin de former la couche d'isolation de la grille (511) ; et

la formation d'une couche conductrice sur la couche d'isolation afin de former l'électrode de grille électriquement conductrice (510).

10. Procédé selon la revendication 9, comprenant une étape de formation d'un deuxième dessin de masques sur un fond de la tranchée (506),

ce deuxième dessin de masques étant utilisé comme faisant partie du masque de dopage lors de l'étape d'application sélective de la première impureté, et

ce deuxième dessin de masques étant enlevé avant l'étape de formation de la couche d'isolation (11) sur la paroi latérale de la tranchée (506).

11. Procédé de fabrication d'un dispositif semi-conducteur de puissance selon l'une quelconque des revendications 1 à 8, ce procédé comprenant les étapes suivantes :

la prévision d'une tranche de semi-conducteur (50 ; 80), cette tranche de semi-conducteur (50 ; 80) comprenant, dans un ordre allant d'un premier côté principal (53 ; 83) de la tranche de semi-conducteur (50 ; 80) à un deuxième côté principal (54 ; 84) de la tranche de semi-conducteur (50 ; 80), une première couche semi-conductrice (501 ; 801) du premier type de conductivité, une deuxième couche semi-conductrice (502 ; 802) du deuxième type de conductivité, et une troisième couche semi-conductrice (503 ; 803) du premier type de conductivité, la première couche semi-conductrice (501; 801) formant la couche de source (55 ; 85) dans le dispositif semiconducteur de puissance (100 ; 200 ; 300 ; 400) et la troisième couche semi-conductrice (503 ; 803) formant la couche de dérive (57 ; 87) dans le dispositif semiconducteur de puissance (100 ; 200 ; 300 ; 400) ;

la formation d'un dessin de masques (604, 605 ; 804, 805 ; 604, 905 ; 1604) sur le premier côté principal (53 ; 83) de la tranche de semi-conducteur (50 ; 80), ce premier dessin de masques (604, 605 ; 804, 805 ; 604, 905 ; 1604) ayant une ouverture ;

l'application sélective d'une première impureté du deuxième type de conductivité à travers la première ouverture dans la tranche de semi-conducteur (50 ; 80) en utilisant le premier dessin de masques (604, 605 ; 804, 805 ; 604, 905 ; 1604) comme premier masque de dopage afin de former la couche de base (56 ; 86) et la région canal (515 ; 815) dans la deuxième couche semi-conductrice (502 ; 802) ;

l'enlèvement d'une partie du premier dessin de masques (604, 605 ; 804, 805 ; 604, 905 ; 1604) afin d'agrandir la première ouverture dans le premier dessin de masques (604, 605 ; 804, 805 ; 604, 905 ; 1604) ;

la formation d'un deuxième dessin de masques (709 ; 809) dans la première ouverture agrandie du premier dessin de masques restant (604 ; 804) ;

la gravure sélective du premier dessin de masques restant (604 ; 804) afin d'exposer la tranche de semi-conducteur (50 ; 80) en dessous du premier dessin de masques restant (604 ; 804) ;

la gravure de la première et de la deuxième couche semi-conductrice (501, 502 ; 801, 802) afin de former une première tranchée (506 ; 816) dans la première et la deuxième couche semi-conductrice (501, 502 ; 801, 802), le deuxième dessin de masques (709 ; 809) étant utilisé comme masque de gravure ;

l'enlèvement du deuxième dessin de masques (709 ; 809) ;

la formation d'une couche d'isolation sur une paroi latérale et un fond de la tranchée afin de former la couche d'isolation de la grille (511) ; et

la formation d'une couche conductrice sur la couche d'isolation afin de former l'électrode de grille électriquement conductrice (510).

12. Procédé selon la revendication 11, dans lequel l'étape de formation d'un premier dessin de masques sur le premier côté principal (53 ; 83) de la tranche de semi-conducteur (50 ; 80) comprend :

une étape de formation d'une première partie de masque (604 ; 804, 805) comportant une deuxième ouverture, et

une étape de formation d'une deuxième partie de masque (605 ; 905 ; 805) au moins sur une paroi latérale de la deuxième ouverture afin de former le premier dessin de masques (604, 605 ; 604, 905 ; 804, 805) comprenant la première et la deuxième partie de masque ; et

l'étape d'enlèvement de la partie du premier dessin de masques (604, 605 ; 804, 805 ; 604, 905) pour agrandir la première ouverture du premier dessin de masques (604, 605 ; 804, 805 ; 604, 905) étant exécutée en gravant sélectivement la deuxième partie de masque (605 ; 805 ; 905).

13. Procédé selon la revendication 11 ou 12, comprenant une étape de formation d'une deuxième tranchée (806) avant l'étape d'application sélective de la première impureté, le premier dessin de masques (804, 805) étant utilisé comme masque de gravure pendant l'étape de formation de la deuxième tranchée (806) .

14. Procédé selon l'une quelconque des revendications 11 à 13, comprenant une étape d'application sélective d'une deuxième impureté du deuxième type de conductivité dans la tranche de semi-conducteur (80) à travers le fond de la première tranchée (806), le deuxième dessin de masques (809) étant utilisé comme deuxième masque de dopage.

FIG. 1

FIG. 2

FIG. 3

FIG. 4

FIG. 5

FIG. 6

FIG. 7

FIG. 8

FIG. 9

FIG. 10A

FIG. 10B

FIG. 10C

FIG. 10D

FIG. 10E

FIG. 10F

FIG. 11A

FIG. 11B

605    609    605

501

502

503

56

FIG. 11C

605    609    605

55            55

606            606

515    56    515

508            508

54

56

FIG. 11D

FIG. 11E

FIG. 11F

605 605 53

604 604
501
502 } 50
503

56 54

## FIG. 12A

56

604 604
501
502 } 50
503

## FIG. 12B

709

604

604

501

502 } 50

503

56

FIG. 12C

709

706

706

55

55

515

515

503

FIG. 12D

FIG. 12E

FIG. 12F

804    805    806    805    804

83

801
802    }80
803

84

FIG. 13A

804    805    806    805    804

83

801
802    }80
803

84

FIG. 13B    86

FIG. 13C

FIG. 13D

FIG. 13E

FIG. 13F

905B

905A

905B

604

604

501

502

50

503

56

FIG. 14

FIG. 15

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2011018004 A1
- US 20080283909 A1
- US 20120080748 A1
- US 20080206944 A1
- US 20060081920 A1
- WO 2015104084 A1
- US 8476697 B1
- US 5547882 A